# EUROPEAN PATENT APPLICATION

(11) **EP 4 730 335 A1**
(43) Date of publication of application: **22.04.2026**
(21) Application number: 25171920.9
(22) Date of filing: 23.04.2025
(51) Int. Cl.: G11C 29/52, G11C 13/00, G11C 16/34, G06F 11/10, G06F 12/02, G11C 16/04, G11C 29/02, G11C 29/04, G11C 29/12, G11C 29/44

(54) **STORAGE DEVICE AND METHOD OF BLOCK RECLAIM IN THE SAME**

(30) Priority: 21.10.2024 KR 20240143761
(71) Applicant: Samsung Electronics Co., Ltd., Suwon-si, Gyeonggi-do 16677 (KR)
(72) Inventor: LEE, Seunghan, Suwon-si, Gyeonggi-do 16677 (KR)
(74) Representative: Kuhnen & Wacker Patent- und Rechtsanwaltsbüro PartG mbB

(57) **Abstract**

A storage device includes a nonvolatile memory device including memory blocks, and a memory controller including an error check code (ECC) circuit that performs ECC encoding and ECC decoding. The memory controller selects a source block to be a target of a block reclaim from among the memory blocks, groups wordlines of the source block into weak wordlines and strong wordlines based on retention characteristics according to physical locations of the wordlines; and controls the nonvolatile memory device to perform an external copyback operation with respect to the weak wordlines and perform an internal copyback operation by the ECC circuit with respect to the strong wordlines, the external copyback operation including error correction by the ECC circuit and the internal copyback operation excluding the error correction by the ECC circuit.

## Description

### BACKGROUND

Example embodiments relate generally to semiconductor integrated circuits, and more particularly to a storage device and a method of block reclaim in the storage device.

Memory devices such as a flash memory device, a resistive memory device, etc., may store data in accordance with a plurality of threshold voltage distributions or a plurality of resistance distributions, where each respective threshold voltage distribution or resistance distribution is assigned to a corresponding logic state for stored data. The data stored by a memory cell may be read by determining whether the memory cell is turned ON/OFF when a predetermined read voltage is applied. During (and/or following) the programming of a memory cell, the intended threshold voltage distribution or resistance distribution of the memory cell may be undesirably distorted due to a number of events or conditions including, e.g., charge leakage, program disturbances, read disturbances, word and/or bitline coupling, temperature change, voltage change, degeneration of the memory cell, etc. For example, the intended threshold voltage distribution or resistance distribution may be shifted and/or broadened and cause a read error such that wrong data different from the stored data are read out.

### SUMMARY

It is an aspect to provide a storage device and a method of block reclaim in a storage device, capable of preventing or reducing occurrence of uncorrectable errors.

According to an aspect of one or more example embodiments, there is provided a method of block reclaim in a storage device including a nonvolatile memory device and a memory controller that controls the nonvolatile memory device, the method comprising selecting a source block to be a target of a block reclaim from among a plurality of memory blocks included in the nonvolatile memory device; grouping a plurality of wordlines of the source block into weak wordlines and strong wordlines based on retention characteristics according to physical locations of the plurality of wordlines; performing an external copyback operation with respect to the weak wordlines, the external copyback operation including error correction; and performing an internal copyback operation with respect to the strong wordlines, the internal copyback operation excluding the error correction.

According to another aspect of one or more example embodiments, there is provided a storage device comprising a nonvolatile memory device including a plurality of memory blocks; and a memory controller including an error check code (ECC) circuit configured to perform ECC encoding and ECC decoding. The memory controller is configured to select a source block to be a target of a block reclaim from among the plurality of memory blocks; group a plurality of wordlines of the source block into weak wordlines and strong wordlines based on retention characteristics according to physical locations of the plurality of wordlines; and control the nonvolatile memory device to perform an external copyback operation with respect to the weak wordlines and perform an internal copyback operation by the ECC circuit with respect to the strong wordlines, the external copyback operation including error correction by the ECC circuit and the internal copyback operation excluding the error correction by the ECC circuit.

According to yet another aspect of one or more example embodiments, there is provided a storage device comprising a nonvolatile memory device including a plurality of memory blocks, each memory block of the plurality of memory blocks including a plurality of wordlines and a plurality of memory cells that are stacked in a vertical direction and formed in a plurality of channel holes; and a memory controller including an error check code (ECC) circuit configured to perform ECC encoding and ECC decoding. The memory controller is configured to select a source block to be a target of a block reclaim from among the plurality of memory blocks, group the plurality of wordlines of the source block into weak wordlines and strong wordlines based on a height in the vertical direction of each wordline of the plurality of wordlines, and control the nonvolatile memory device to perform an external copyback operation with respect to the weak wordlines and perform an internal copyback operation with respect to the strong wordlines, the external copyback operation including error correction by the ECC circuit and the internal copyback operation excluding the error correction by the ECC circuit. The nonvolatile memory device is configured to transfer read data read from memory cells connected to a weak wordline of the source block to the memory controller in the external copyback operation, and not transfer read data read from memory cells connected to a strong wordline of the source block to the memory controller in the internal copyback operation.

### BRIEF DESCRIPTION OF THE DRAWINGS

Example embodiments will be more clearly understood from the following detailed description taken in conjunction with the accompanying drawings.
FIG. 1 is a block diagram illustrating a storage device according to example embodiments.
FIG. 2 is a flowchart illustrating a method of block reclaim in a storage device according to example embodiments.
FIG. 3 is a block diagram illustrating an example embodiment of a memory controller included in a memory system according to example embodiments.
FIG. 4 is a block diagram illustrating a nonvolatile memory device according to example embodiments.
FIG. 5 is a block diagram illustrating a storage device according to example embodiments.
FIG. 6 is a block diagram illustrating a memory cell array included in the nonvolatile memory device of FIG. 4, according to example embodiments.
FIG. 7 is a circuit diagram illustrating an equivalent circuit of a memory block included in the memory cell array of FIG. 6, according to example embodiments.
FIG. 8 is a diagram illustrating example states of multi-level cells included in a nonvolatile memory device according to example embodiments.
FIG. 9 is a diagram illustrating degenerated states from the states of FIG. 8.
FIG. 10 is a sequence diagram illustrating an external copyback operation of a storage device according to example embodiments.
FIG. 11 is a diagram illustrating a data flow according to the external copyback operation of FIG. 10, according to example embodiments.
FIG. 12 is a sequence diagram illustrating an internal copyback operation of a storage device according to example embodiments.
FIG. 13 is a diagram illustrating a data flow according to the internal copyback operation of FIG. 12, according to example embodiments.
FIG. 14 is a diagram illustrating an example structure of a cell string of a nonvolatile memory device according to example embodiments.
FIGS. 15 and 16 are diagrams illustrating retention characteristic information of a method of block reclaim in a storage device, according to example embodiments.
FIG. 17 is a diagram illustrating changing retention characteristic information of a method of block reclaim in a storage device, according to example embodiments.
FIG. 18 is a diagram illustrating a program method in a storage device according to example embodiments.
FIGS. 19 and 20 are diagrams illustrating an execution order of a method of block reclaim in the storage device, according to example embodiments.
FIG. 21 is a diagram illustrating a program method in a storage device according to example embodiments.
FIG. 22 is a circuit diagram illustrating a structure of a memory cell array included in a nonvolatile memory device, according to example embodiments.
FIG. 23 is a diagram illustrating a memory block corresponding to the structure of FIG. 22, according to example embodiments.
FIG. 24 is a cross-sectional diagram illustrating a boundary layer included in a nonvolatile memory device, according to example embodiments.
FIG. 25 is a diagram illustrating a memory block included in a nonvolatile memory device, according to example embodiments.
FIG. 26 is a diagram illustrating an example retention characteristic and retention characteristic information of a nonvolatile memory device, according to example embodiments.
FIG. 27 is a flowchart illustrating determining a source block of a method of block reclaim in a storage device, according to example embodiments.
FIG. 28 is a diagram illustrating source block determination information corresponding to the method of FIG. 27, according to example embodiments.
FIG. 29 is a flowchart illustrating determining a source block of a method of block reclaim in a storage device, according to example embodiments.
FIG. 30 is a diagram illustrating source block determination information corresponding to the method of FIG. 29, according to example embodiments.
FIG. 31 is a block diagram illustrating a data center including a storage device according to example embodiments.
FIG. 32 is a cross-section diagram illustrating a nonvolatile memory device according to example embodiments.
FIG. 33 is a diagram for describing manufacturing processes of a stacked semiconductor device according to example embodiments.

### DETAILED DESCRIPTION

Various example embodiments will be described more fully hereinafter with reference to the accompanying drawings, in which some example embodiments are shown. In the drawings, like numerals refer to like elements throughout. The repeated descriptions may be omitted for conciseness.

The storage device and the method of a block reclaim according to example embodiments may efficiently prevent or reduce the occurrence of uncorrectable errors and improve the reliability and performance of the storage device by selectively performing the external copyback operation or the internal copyback operation based on retention characteristics according to physical locations of wordlines.

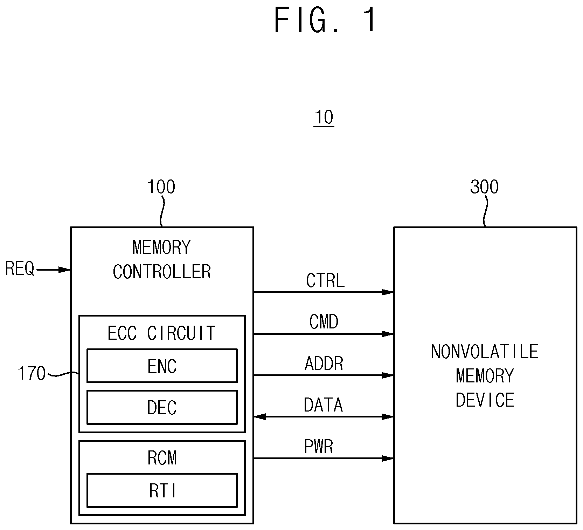

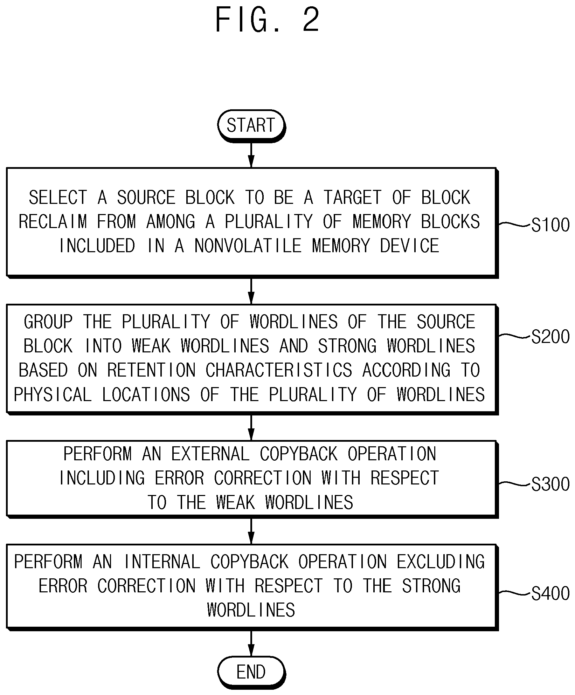

FIG. 1 is a block diagram illustrating a storage device according to example embodiments, and FIG. 2 is a flowchart illustrating a method of block reclaim in a storage device according to example embodiments.

Referring to FIG. 1, a memory system 10 may include a memory controller (or storage controller) 100 and at least one nonvolatile memory device 300. The memory system 10 illustrated in FIG. 1 may include a data storage medium based on flash memory, such as a memory card, USB memory, SSD, or the like.

The nonvolatile memory device 300 may perform erase, write, or read operations, or the like, under control of the memory controller 100. The nonvolatile memory device 300 receives commands CMD such as read commands and write commands, and addresses ADDR such as read addresses and write addresses, from the memory controller 100 via input and output lines, and transfers and receives data DATA for the read operations or the write operations (or program operations) with the memory controller 100. The nonvolatile memory device 300 may receive a control signal CTRL via a control line, and the nonvolatile memory device 300 may receive power PWR from the memory controller 100.

The memory controller 100 may control access to the nonvolatile memory device 300 based on requests REQ received from an external host device. The memory controller 100 may include an error check code (ECC) circuit 170 and a reclaim manager RCM.

The ECC engine 170 may include an ECC encoder ENC and an ECC decoder DEC. The ECC encoder ENC may perform ECC encoding on write data to be stored in the nonvolatile memory device 300 to generate encoded data, i.e., codewords. The ECC decoder DEC may perform ECC decoding on the read data in the form of codewords read from the nonvolatile memory device 300 to correct errors in the read data.

The reclaim manager RCM may manage and control a block reclaim operation as will be described below. The reclaim manager RCM may be implemented in the form of hardware, software, or firmware, or a combination thereof.

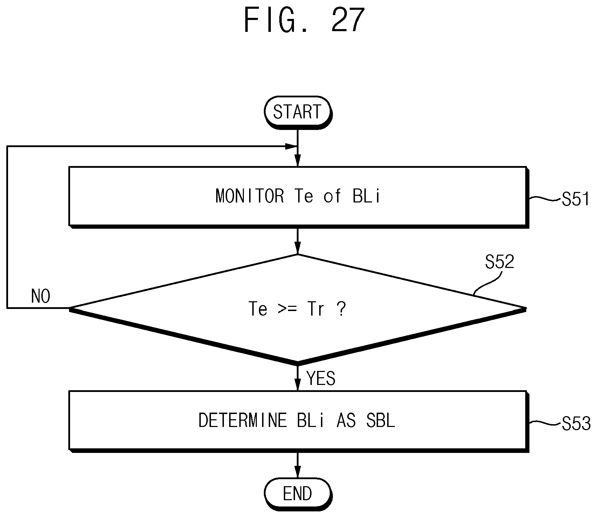

Referring to FIGS. 1 and 2, the reclaim manager RCM may select a source block to be a target of a block reclaim from among a plurality of memory blocks included in the nonvolatile memory device 300 (S100). The block reclaim refers to moving and storing data of a source block to a destination block. The source block may be selected in various ways, and example embodiments of determining the source block will be described below with reference to FIGS. 27 through 30.

The reclaim manager RCM may group the plurality of wordlines of the source block into weak wordlines and strong wordlines based on retention characteristics according to physical locations of the plurality of wordlines of the source block (S200). The weak wordlines represent wordlines connected to memory cells with a relatively high possibility of error occurrence, and the strong wordlines represent wordlines connected to memory cells with a relatively low possibility of error occurrence. The reclaim manager RCM may store a result of the grouping as retention characteristic information RTI, and may efficiently control the block reclaim based on the retention characteristic information RTI.

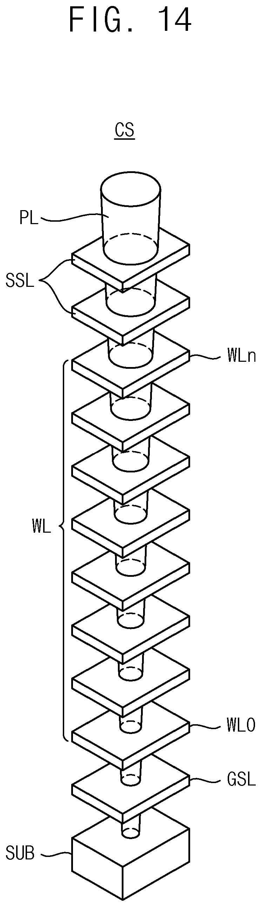

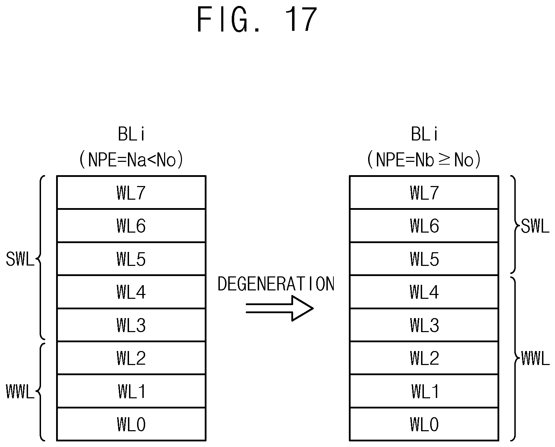

As will be described below with reference to FIGS. 14 through 16, the retention characteristic information RTI may be determined in advance according to the physical structure of the nonvolatile memory device 300. In an example embodiment, as will be described below with reference to FIG. 17, as the deterioration of the retention characteristic of the memory block increases, the number of the weak wordlines may be increased and the number of the strong wordlines may be decreased.

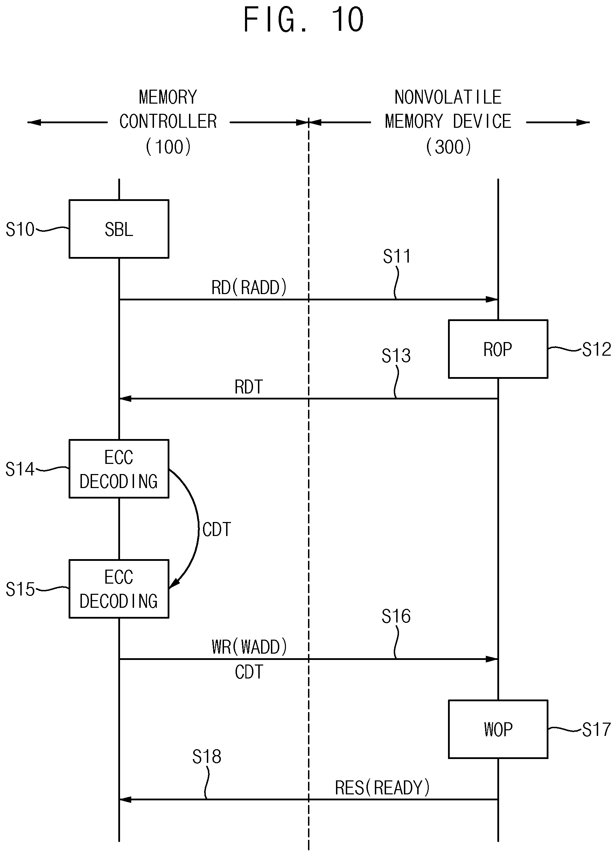

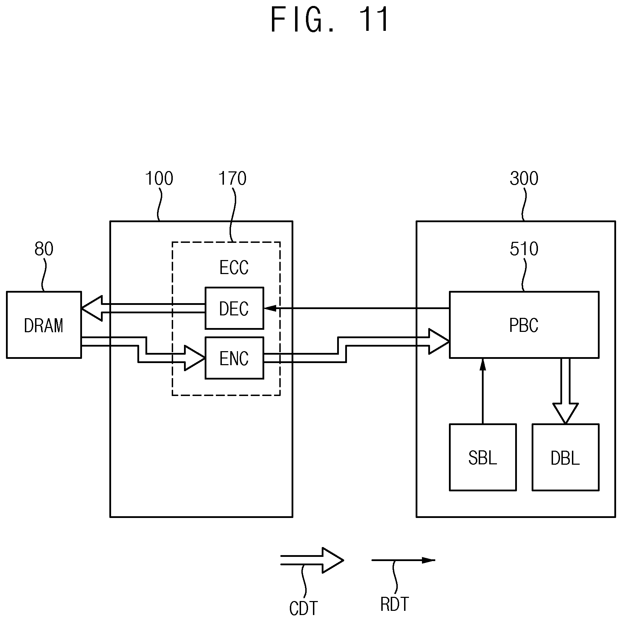

The reclaim manager RCM may control the nonvolatile memory device 300 to perform an external copyback operation that includes error correction by the ECC circuit 170 with respect to the weak wordlines of the source block (S300). The external copyback operation will be described below with reference to FIGS. 10 and 11.

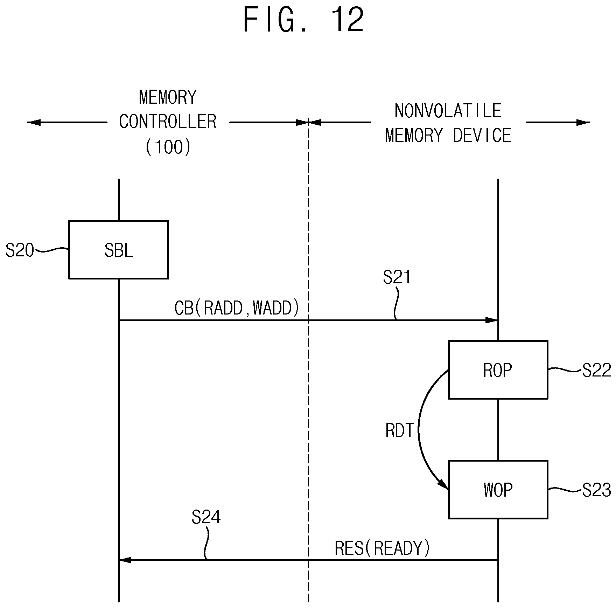

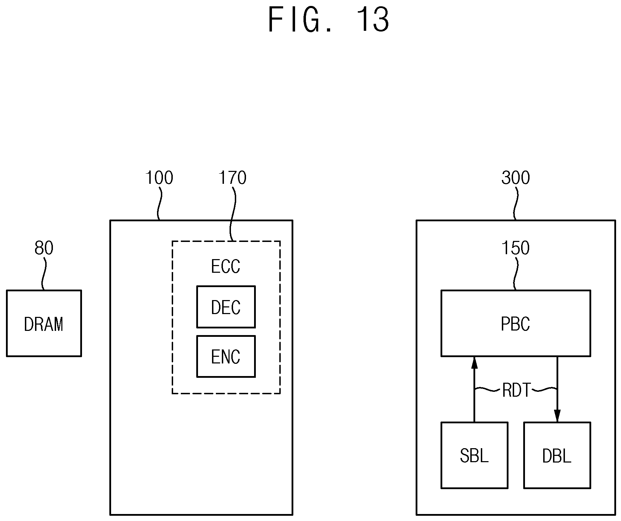

In contrast, the reclaim manager RCM may control the nonvolatile memory device 300 to perform an internal copyback operation that excludes the error correction by the ECC circuit 170 with respect to the strong wordlines (S400). The internal copyback operation will be described below with reference to FIGS. 12 and 13.

In an example embodiment, as will be described below with reference to FIGS. 10 through 13, the nonvolatile memory device 300 may, in the external copyback operation, transfer read data that are read from memory cells connected to the weak wordline of the source block to the memory controller 100. On the other hand, in the internal copyback operation, read data that is read from memory cells connected to the strong wordline of the source block may not be transferred to the memory controller 100. In the external copyback operation, the ECC circuit 170 of the memory controller 100 may correct errors in the read data read that is read from the memory cells connected to the weak wordline of the source block and transfer the corrected data to the nonvolatile memory device 300. The nonvolatile memory device 300 may write the corrected data in a destination block that is determined among the plurality of memory blocks. On the other hand, in the internal copyback operation, the nonvolatile memory device 300 may write the read data that are read from the memory cells connected to the strong wordline of the source block as the read data is (i.e., without correcting errors in the read data) in the destination block.

For weak wordlines with a relatively high possibility of error occurrence, the occurrence of uncorrectable errors may be reduced or prevented by correcting errors using the ECC circuit 170. On the other hand, for strong wordlines with a relatively low possibility of error occurrence, the operations for performing block reclaim of the storage device 10 may be reduced and a time used for block reclaim may be reduced by omitting transfer of the read data, the ECC decoding of read data, the ECC encoding of the corrected data, and transfer of the corrected data.

With the above configuration and operation, the storage device 10 and the block reclaim method according to example embodiments may efficiently prevent or reduce the occurrence of uncorrectable errors and improve the reliability and performance of the storage device 10 by selectively performing the external copyback operation or the internal copyback operation based on retention characteristics according to physical locations of the wordlines.

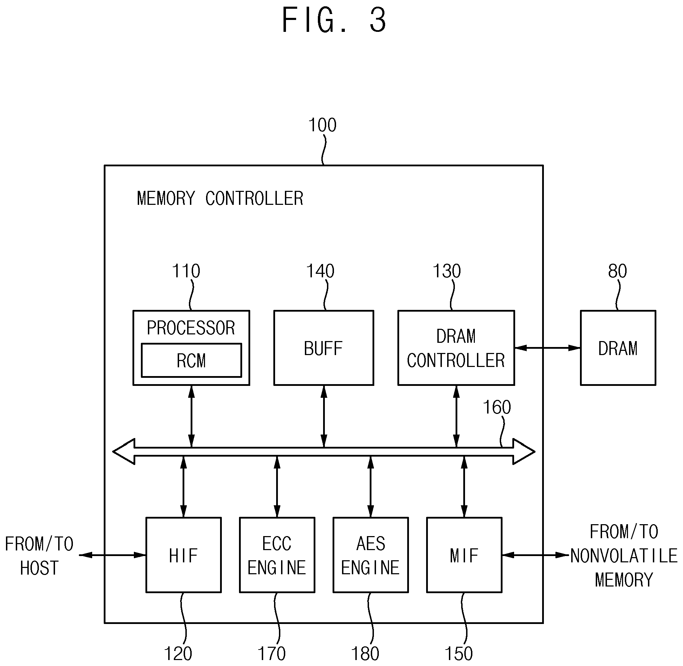

FIG. 3 is a block diagram illustrating an example embodiment of a memory controller included in a memory system according to example embodiments.

Referring to FIG. 3, a memory controller or storage controller 100 may include a processor 110, a buffer memory (BUFF) 140, a DRAM controller 130, a host interface (HIF) 120, an error correction code (ECC) engine 170, a memory interface (MIF) 150, an advanced encryption standard (AES) engine 180, and an internal bus 160 electrically connecting the processor 110, the buffer memory (BUFF) 140, the DRAM controller 130, the host interface (HIF) 120, the error correction code (ECC) engine 170, the memory interface (MIF) 150, and the advanced encryption standard (AES) engine 180.

The processor 110 may control the operation of the storage controller 100 in response to commands received via the host interface 120 from an external host device. For example, the processor 110 may control the operation of a memory system (e.g., 10 in FIG. 1) and may employ firmware to drive the memory system 10 to control respective components. In some example embodiments, the reclaim manager RCM described above with reference to FIGS. 1 and 2 may be implemented as hardware corresponding to a portion of the processor 110. In some example embodiments, the reclaim manager RCM may be implemented as software or firmware executed by the processor 110.

The buffer memory (BUFF) 140 may store instructions and data that are executed and processed by the processor 110. For example, the buffer memory 140 may be implemented as volatile memory, such as SRAM, DRAM, or the like.

The ECC engine 170 for error correction may perform ECC encoding and ECC decoding using error correction code such as Bose-Chaudhuri-Hocquenghem (BCH) code, Low Density Parity Check (LDPC) code, Turbo Code, Reed-Solomon Code, Convolution Code, Recursive Systematic Code (RSC), Coded Modulation, such as Trellis-Coded Modulation (TCM), Block Coded Modulation (BCM), Hamming code, and so on.

The host interface (HIF) 120 may provide a physical connection between the host device and the storage controller 100, i.e., the host interface 120 may provide interfacing with the storage controller 100 in a bus format corresponding to the bus format of the host device. In an example embodiment, the bus format of the host device may be SCSI or SAS. In some example embodiments, the bus format of the host device may be USB, peripheral component interconnect express (PCIe), ATA, PATA, SATA, NVMe, or the like.

The memory interface (MIF) 150 may exchange data with a nonvolatile memory device (e.g., 300 in FIG. 1). The memory interface 150 may transfer write data to the nonvolatile memory device 300, and may receive read data from the nonvolatile memory device 300. For example, the memory interface 150 may utilize a standard protocol such as Toggle or ONFI.

The AES engine 180 may perform at least one of encryption operations and decryption operations on data input to the storage controller 100, using a symmetric-key algorithm. Although not shown in detail, the AES engine 180 may include an encryption module and a decryption module. Depending on example embodiment, the encryption module and the decryption module may be implemented as separate modules or may be implemented as a single module.

The processor 110 may access an external DRAM 80 via the DRAM controller 130. The processor 110 may control the DRAM controller 130, the memory interface 150, and the host interface 120 to transfer user data stored in the external DRAM 80 to the nonvolatile memory device 300 or to an external host device.

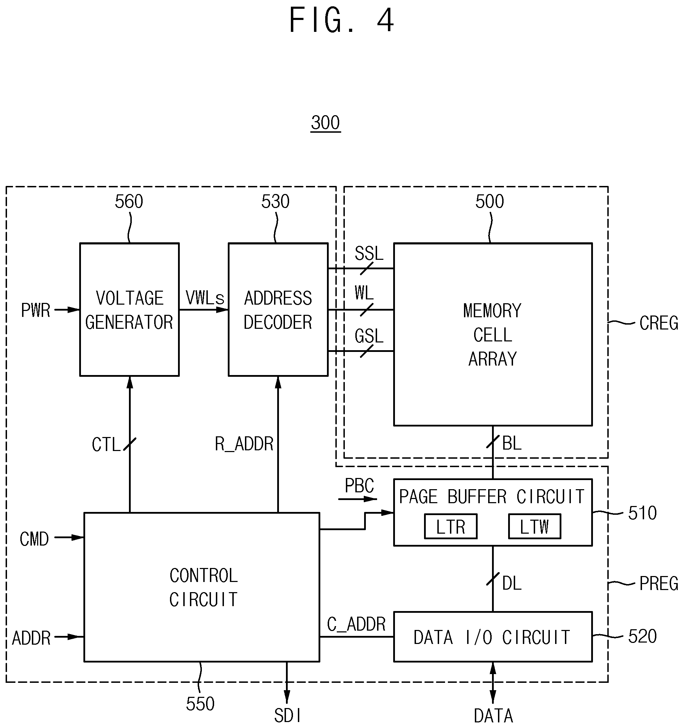

FIG. 4 is a block diagram illustrating a nonvolatile memory device according to example embodiments.

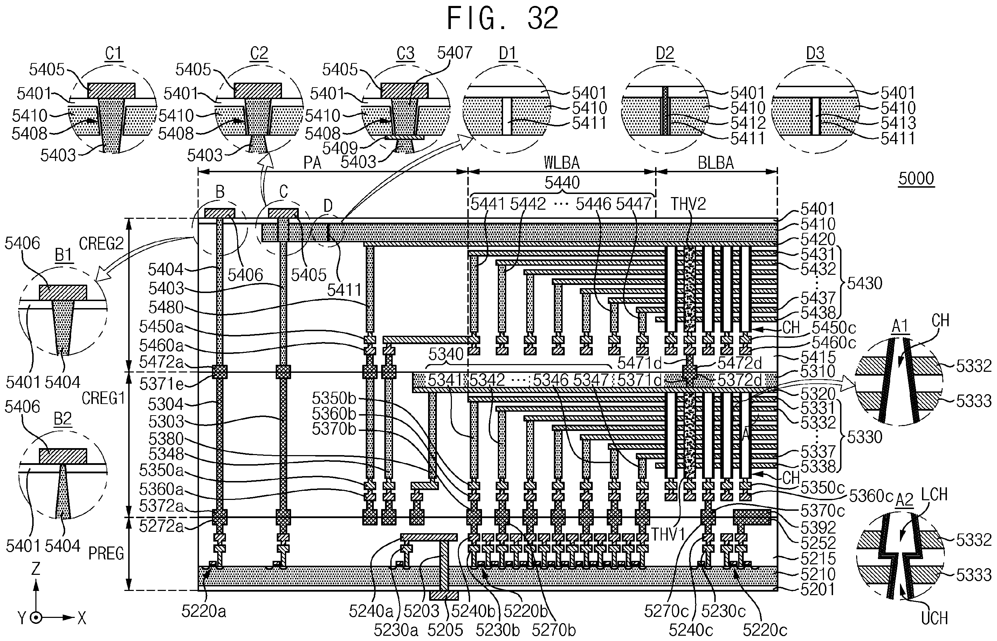

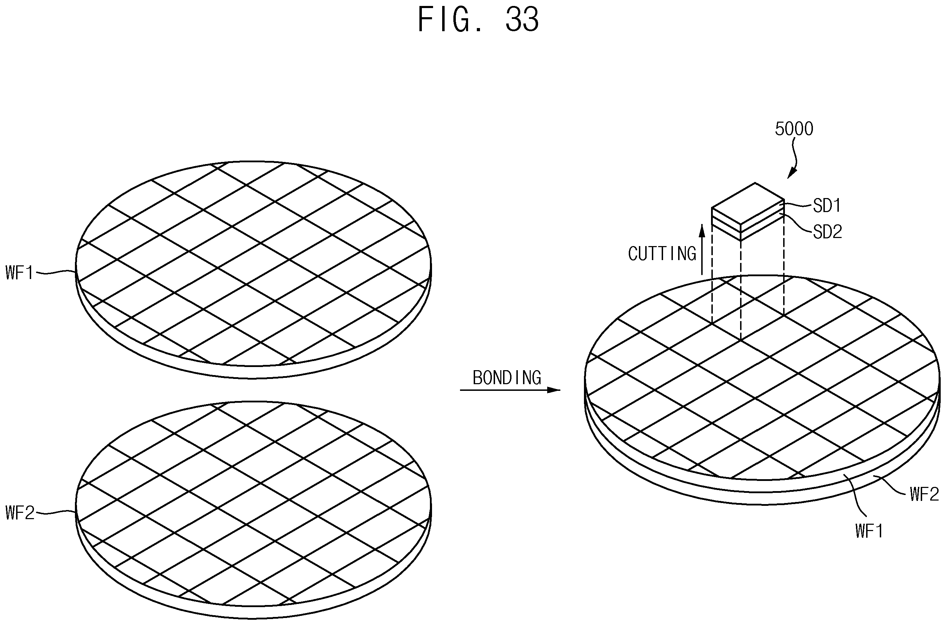

Referring to FIG. 4, a nonvolatile memory device 300 may include a memory cell array 500, a page buffer circuit 510, a data input/output (I/O) circuit 520, an address decoder 530, a control circuit 550, and a voltage generator 560. As will be described below with reference to FIGS. 32 and 33, the cell region CREG and the peripheral region PREC may be formed and disposed in different wafers.

The memory cell array 500 may be coupled to the address decoder 530 through string selection lines SSL, wordlines WL, and ground selection lines GSL. The memory cell array 500 may be coupled to the page buffer circuit 510 through bitlines BL. The memory cell array 500 may include memory cells coupled to the wordlines WL and the bitlines BL. In some example embodiments, the memory cell array 500 may be a three-dimensional memory cell array, which is formed on a substrate in a three-dimensional structure (for example, a vertical structure). In this case, the memory cell array 500 may include cell strings (e.g., NAND strings) that are vertically oriented such that at least one memory cell is overlapped vertically with another memory cell.

The control circuit 550 may receive a command (signal) CMD and an address (signal) ADDR from a memory controller. Accordingly, the control circuit 550 may control erase, program and read operations of the nonvolatile memory device 300 in response to (or based on) at least one of the command signal CMD and the address signal ADDR. An erase operation may include performing a sequence of erase loops. A program operation may include performing a sequence of program loops. Each program loop may include a program operation and a program verification operation. Each erase loop may include an erase operation and an erase verification operation. The read operation may include a normal read operation and a data recover read operation.

For example, the control circuit 550 may generate the control signals CTL used to control the operation of the voltage generator 560. The control circuit 550 may generate the page buffer control signal PBC for controlling the page buffer circuit 510 based on the command signal CMD, and generate the row address R_ADDR and the column address C_ADDR based on the address signal ADDR. The control circuit 550 may provide the row address R_ADDR to the address decoder 530 and provide the column address C_ADDR to the data I/O circuit 520.

The address decoder 530 may be coupled to the memory cell array 500 through the string selection lines SSL, the wordlines WL, and the ground selection lines GSL. During the program operation or the read operation, the address decoder 530 may determine or select one of the wordlines WL as a selected wordline and determine the remaining wordlines WL except for the selected wordline as unselected wordlines based on the row address R_ADDR.

During the program operation or the read operation, the address decoder 530 may determine one of the string selection lines SSL as a selected string selection line and determine the remaining string selection lines SSL except for the selected string selection line as unselected string selection lines based on the row address R_ADDR.

The voltage generator 560 may generate wordline voltages VWL, which are required for the operation of the memory cell array 500 of the nonvolatile memory device 300, based on the control signals CTL. The voltage generator 560 may receive power PWR from a memory controller such as the memory controller 100 in FIG. 1. The wordline voltages VWL may be applied to the wordlines WL through the address decoder 530.

For example, during the erase operation, the voltage generator 560 may apply an erase voltage to a well and/or a common source line of a memory block and apply an erase permission voltage (e.g., a ground voltage) to all or a portion of the wordlines of the memory block based on an erase address. During the erase verification operation, the voltage generator 560 may apply an erase verification voltage simultaneously to all of the wordlines of the memory block or sequentially (e.g., one by one) to the wordlines.

For example, during the program operation, the voltage generator 560 may apply a program voltage to the selected wordline and may apply a program pass voltage to the unselected wordlines. In addition, during the program verification operation, the voltage generator 560 may apply a program verification voltage to the first wordline and may apply a verification pass voltage to the unselected wordlines.

During the normal read operation, the voltage generator 560 may apply a read voltage to the selected wordline and may apply a read pass voltage to the unselected wordlines. During the data recover read operation, the voltage generator 560 may apply the read voltage to a wordline adjacent to the selected wordline and may apply a recover read voltage to the selected wordline.

The page buffer circuit 510 may be coupled to the memory cell array 500 through the bitlines BL. The page buffer circuit 510 may include multiple buffers. In some example embodiments, each buffer may be connected to a single bitline. In some example embodiments, each buffer may be connected to two or more bitlines. The page buffer circuit 510 may temporarily store data to be programmed in a selected page or data read out from the selected page of the memory cell array 500.

The page buffer circuit 510 may include a first latch LTR for storing read data and a second latch LTW for storing write data. During the internal copyback operation described above, read data read from the strong wordline of the source block may be stored in the first latch LTR. Thereafter, the read data stored in the first latch LTR may be stored in the second latch LTW as write data for writing to the target block.

The data I/O circuit 520 may be coupled to the page buffer circuit 510 through data lines DL. During the program operation, the data I/O circuit 520 may receive program data DATA received from the memory controller and provide the program data DATA to the page buffer circuit 510 based on the column address C_ADDR received from the control circuit 550. During the read operation, the data I/O circuit 520 may provide read data DATA, having been read from the memory cell array 500 and stored in the page buffer circuit 510, to the memory controller based on the column address C_ADDR received from the control circuit 550.

The page buffer circuit 510 and the data I/O circuit 520 may read data from a first area of the memory cell array 500 and write the read data to a second area of the memory cell array 500 (e.g., without transferring the data to a source external to the nonvolatile memory device 1000, such as to the memory controller). For example, the page buffer circuit 510 and the data I/O circuit 520 may perform a copy-back operation.

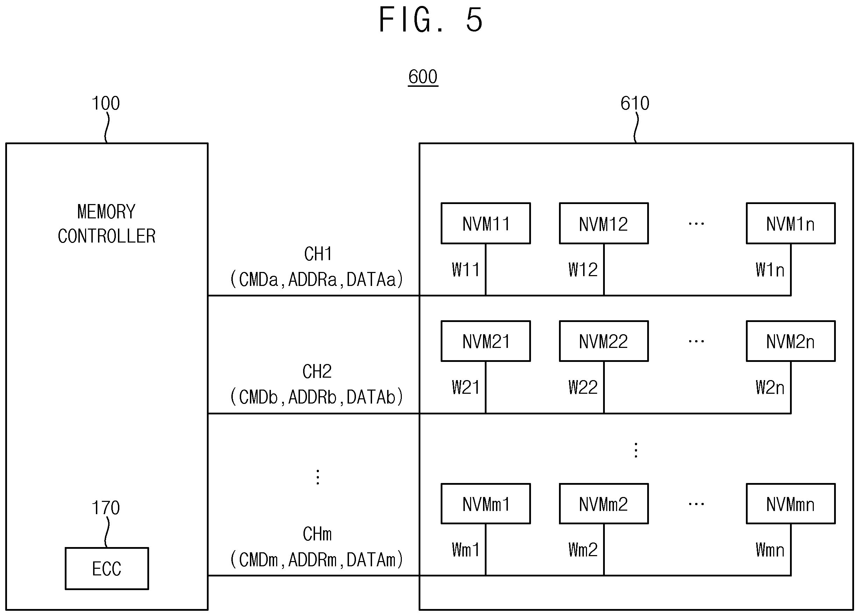

FIG. 5 is a block diagram illustrating a storage device according to example embodiments.

Referring to FIG. 5, a memory system or a storage device 600 may include a nonvolatile memory device 610 and a memory controller 100. The storage device 600 may support a plurality of channels CH1, CH2, ..., CHm, and nonvolatile the memory device 610 may be connected to the memory controller 100 through the plurality of channels CH1 to CHm. For example, the storage device 600 may be implemented as a universal flash storage (UFS), a solid state drive (SSD), or the like. The storage device 600 may correspond to the memory system 10 of FIG. 1.

The nonvolatile memory device 610 may include a plurality of nonvolatile memories NVM11, NVM12, ..., NVM1n, NVM21, NVM22, ..., NVM2n, NVMm1, NVMm2, ..., NVMmn. Here, n and m may each be integers. Each of the nonvolatile memories NVM11 to NVMmn may be connected to one of the plurality of channels CH1 to CHm through a way corresponding thereto. For example, the nonvolatile memories NVM11 to NVM1n may be connected to the first channel CH1 through ways W11, W12, ..., W1n, the nonvolatile memories NVM21 to NVM2n may be connected to the second channel CH2 through ways W21, W22, ..., W2n, and the nonvolatile memories NVMm1 to NVMmn may be connected to the m-th channel CHm through ways Wm1, Wm2, ..., Wmn. In some example embodiments, each of the nonvolatile memories NVM11 to NVMmn may be implemented as a memory unit that may operate according to an individual command from the memory controller 100. For example, each of the nonvolatile memories NVM11 to NVMmn may be implemented as a chip or a die, but example embodiments are not limited thereto.

The memory controller 100 may transmit and receive signals to and from the nonvolatile memory device 610 through the plurality of channels CH1 to CHm. For example, the memory controller 100 may transmit commands CMDa, CMDb, ..., CMDm, addresses ADDRa, ADDRb, ..., ADDRm and data DATAa, DATAb, ..., DATAm to the nonvolatile memory device 610 through the channels CH1 to CHm, or may receive the data DATAa to DATAm from the nonvolatile memory device 610 through the channels CH1 to CHm.

The memory controller 100 may select one of the nonvolatile memories NVM11 to NVMmn, which is connected to each of the channels CH1 to CHm, using a corresponding one of the channels CH1 to CHm, and may transmit and receive signals to and from the selected nonvolatile memory. For example, the memory controller 100 may select the nonvolatile memory NVM11 from among the nonvolatile memories NVM11 to NVM1n connected to the first channel CH1. The memory controller 100 may transmit the command CMDa, the address ADDRa and the data DATAa to the selected nonvolatile memory NVM11 through the first channel CH1 or may receive the data DATAa from the selected nonvolatile memory NVM11 through the first channel CH1.

The memory controller 100 may transmit and receive signals to and from the nonvolatile memory device 610 in parallel through different channels. For example, the memory controller 100 may transmit the command CMDb to the nonvolatile memory device 610 through the second channel CH2 while transmitting the command CMDa to the nonvolatile memory device 610 through the first channel CH1. For example, the memory controller 100 may receive the data DATAb from the nonvolatile memory device 610 through the second channel CH2 while receiving the data DATAa from the nonvolatile memory device 610 through the first channel CH1.

The memory controller 100 may control overall operations of the nonvolatile memory device 610. The memory controller 100 may transmit a signal to the channels CH1 to CHm and may control each of the nonvolatile memories NVM11 to NVMmn connected to the channels CH1 to CHm. For example, the memory controller 100 may transmit the command CMDa and the address ADDRa to the first channel CH1 and may control one selected from among the nonvolatile memories NVM11 to NVM1n.

Each of the nonvolatile memories NVM11 to NVMmn may operate under the control of the memory controller 100. For example, the nonvolatile memory NVM11 may program the data DATAa based on the command CMDa, the address ADDRa and the data DATAa provided from the memory controller 100 through the first channel CH1. For example, the nonvolatile memory NVM21 may read the data DATAb based on the command CMDb and the address ADDRb provided from the memory controller 100 through the second channel CH2 and may transmit the read data DATAb to the memory controller 100 through the second channel CH2.

Although FIG. 5 illustrates an example where the nonvolatile memory device 610 communicates with the memory controller 100 through m channels and includes n nonvolatile memories corresponding to each of the channels, example embodiments are not limited thereto and, in some example embodiments, the number of channels and the number of nonvolatile memories connected to one channel may be variously changed.

According to example embodiments, the storage controller 100 may include an ECC engine 170, and wordlines of the plurality of nonvolatile memories NVM11, NVM12, ..., NVM1n, NVM21, NVM22, ..., NVM2n, NVMm1, NVMm2, ..., NVMmn may be grouped into weak wordlines and strong wordlines.

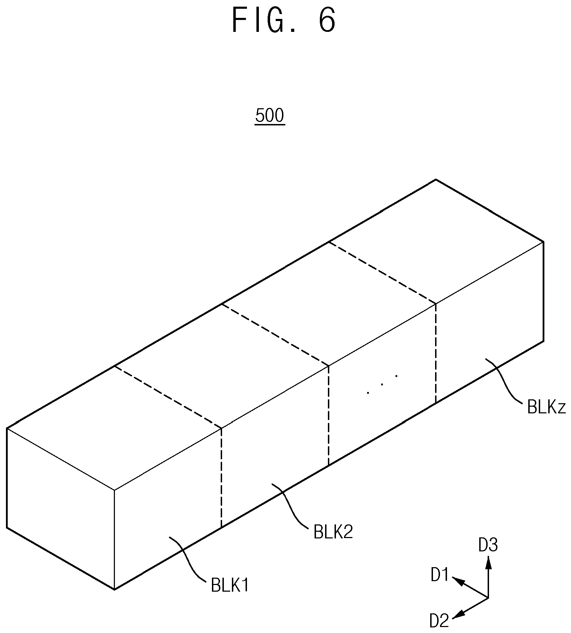

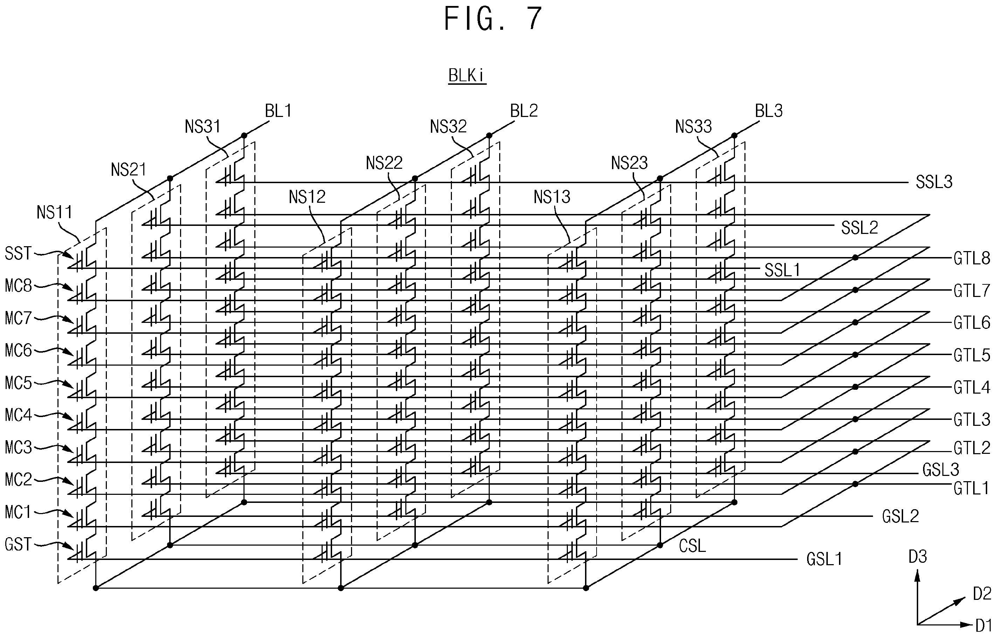

FIG. 6 is a block diagram illustrating a memory cell array included in the nonvolatile memory device of FIG. 4, and FIG. 7 is a circuit diagram illustrating an equivalent circuit of a memory block included in the memory cell array of FIG. 6.

Hereinafter, two directions that are parallel to an upper surface of a semiconductor substrate and intersect each other are defined as a first direction D1 and a second direction D2, respectively, and the direction that is substantially perpendicular to the upper surface of the semiconductor substrate is defined as a third direction D3. For example, the first direction D1 and the second direction D2 may intersect each other substantially perpendicularly. The first direction D1 may be referred to as a row direction, the second direction D2 may be referred to as a column direction, and the third direction D3 may be referred to as a vertical direction. The direction indicated by an arrow in the drawing and its opposite direction are described as the same direction. The definition of the above-mentioned directions may be the same in all drawings thereafter.

Referring to FIG. 6, the memory cell array 500 may include memory blocks BLK1 to BLKz. Here, z may be an integer. In some example embodiments, the memory blocks BLK1 to BLKz may be selected by the address decoder 530 in FIG. 4. For example, the address decoder 530 may select a particular memory block BLK among the memory blocks BLK1 to BLKz corresponding to a block address.

The memory block BLKi of FIG. 7 may be formed on a substrate in a three-dimensional structure (for example, a vertical structure). For example, NAND strings or cell strings included in the memory block BLKi may be disposed in the vertical direction D3 perpendicular to the upper surface of the substrate.

Referring to FIG. 7, the memory block BLKi may include cell strings or NAND strings NS11 to NS33 coupled between bitlines BL1, BL2 and BL3 and a common source line CSL. Each NAND string may include a plurality of memory cells stacked in the vertical direction D3, and the plurality of wordlines may be stacked in the vertical direction D3.

Each of the NAND strings NS11 to NS33 may include a string selection transistor SST, memory cells MC1 to MC8, and a ground selection transistor GST. In FIG. 7, each of the NAND strings NS11 to NS33 is illustrated to include eight memory cells MC1 to MC8. However, example embodiments are not limited thereto. In some example embodiments, each of the NAND strings NS11 to NS33 may include any number of memory cells.

Each string selection transistor SST may be connected to a corresponding string selection line (for example, one of SSL1 to SSL3). The memory cells MC1 to MC8 may be connected to corresponding gate lines GTL1 to GTL8, respectively. The gate lines GTL1 to GTL8 may be wordlines. Some of the gate lines GTL1 to GTL8 may be dummy wordlines. Each ground selection transistor GST may be connected to a corresponding ground selection line (for example, one of GSL1 to GSL3). Each string selection transistor SST may be connected to a corresponding bitline (e.g., one of BL1, BL2 and BL3). Each ground selection transistor GST may be connected to the common source line CSL.

The wordline (each of the gate lines GTL1 to GTL8) having the same height may be commonly connected. The ground selection lines GSL1 to GSL3 and the string selection lines SSL1 to SSL3 may be separated. In FIG. 7, the memory block BLKi is illustrated to be coupled to eight gate lines GTL1 to GTL8 and three bitlines BL1 to BL3. However, example embodiments are not limited thereto. In some example embodiments, each memory block in the memory cell array 500 may be coupled to any number of wordlines and any number of bitlines.

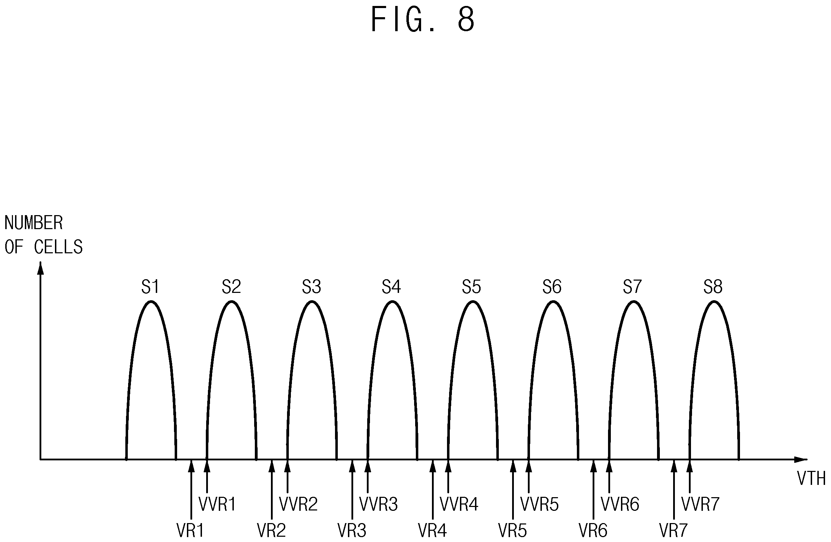

FIG. 8 is a diagram illustrating example states of multi-level cells included in a nonvolatile memory device according to example embodiments.

FIG. 8 illustrates first through eighth states S1~S8 of a triple level cell (TLC) memory where each memory cell of the TLC memory may store three data bits. In FIG. 8, the horizontal axis represents a threshold voltage VTH of memory cells and the vertical axis represents the number of the memory cells corresponding to the threshold voltage VTH. During the program operation, the program success of the first through eighth states S1~S8 may be distinguished by respectively applying first through seventh verification read voltage VVR1~VVR7 to the selected wordline.

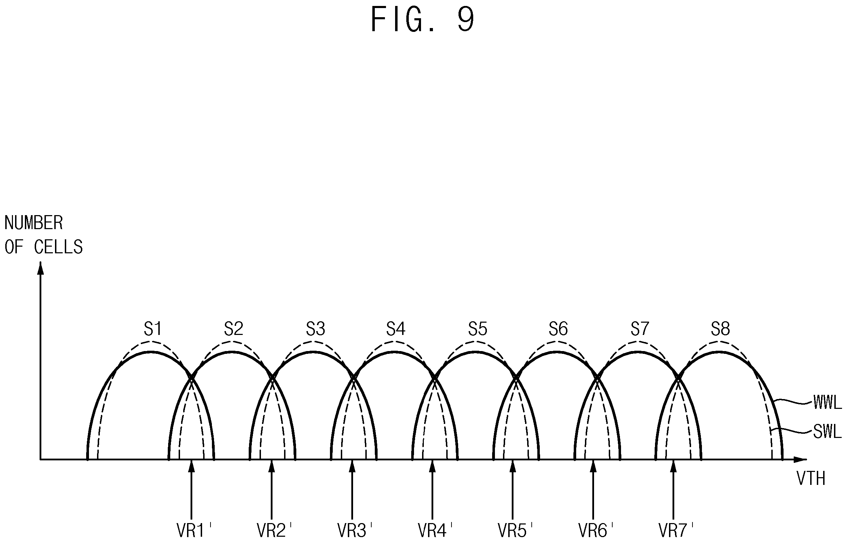

FIG. 9 is a diagram illustrating degenerated states from the states of FIG. 8.

The threshold voltage distributions with respect to the states S1~S8 of FIG. 8 may be degenerated as illustrated in FIG. 9. During or after programming of memory cells, the intended distributions may be undesirably distorted due to a number of events or conditions including (e.g.,) charge leakage, program disturbances, read disturbances, wordline and/or bitline coupling, temperature change, voltage change, degeneration of the memory cells by repeated programming and erasing, etc. For example, the intended distributions may be shifted and/or broadened.

According to the degeneration degree of the memory cells, the read operation based on the read voltages VR1~VR7 in FIG. 8 may cause a read fail such that wrong data different from the stored data are read out. When the read fail occurs, the nonvolatile memory device may perform a recovery read operation such that the optimal read voltages VR1'~VR7' as illustrated in FIG. 9 are searched to try another read operation based on the optimal read voltages VR1'~VR7'. However, if the degeneration degree is serious, it may be impossible to discern the states S1~S7 even by the optimal read voltages VR1'~VR7'. In addition, obtaining the optimal read voltages VR1'~VR7' may take a long time, thereby degrading the performance of the memory system.

As illustrated in FIG. 9, the threshold voltage distribution of the memory cells connected to the weak wordlines WWL may be degraded more severely than the threshold voltage distribution of the memory cells connected to the strong wordlines SWL. According to example embodiments, by performing the external copyback operation including error correction with respect to the weak wordlines WWL having a relatively high error probability and performing the internal copyback operation without error correction with respect to the weak wordlines WWL having a relatively low error probability, a block reclaim may be efficiently performed and the occurrence of uncorrectable errors may be reduced or prevented.

FIG. 10 is a sequence diagram illustrating an external copyback operation of a storage device according to example embodiments, and FIG. 11 is a diagram illustrating a data flow according to the external copyback operation of FIG. 10, according to example embodiments.

Referring to FIGS. 1, 4, 10, and 11, the reclaim manager RCM may select a source block SBL to be a target of a block reclaim as described above (S10). The reclaim manager RCM may transfer a read command RD including a read row address RADD corresponding to a weak wordline WWL of the source block SBL to the nonvolatile memory device 300 (S12). The nonvolatile memory device 300 may perform a read operation ROP with respect to the read row address RADD of the source block SBL (S12) to store read data RDT in the page buffer circuit 510 and transfer the read data RDT to the memory controller 100 (S13). The ECC circuit 170 of the memory controller 100 may perform ECC decoding on the read data RDT to generate corrected data CDT (S14) and perform ECC encoding on the corrected data CDT (S15).

The reclaim manager RCM may transfer a write command WR including a write row address WADD corresponding to a wordline of a destination block together with corrected data CDT in the form of a codeword to the nonvolatile memory device 300 (S16).

The nonvolatile memory device 300 may store the received corrected data CDT in the page buffer circuit 510. The nonvolatile memory device 300 may perform a write operation WOP to write the corrected data CDT stored in the page buffer circuit 510 to the write address WADD of the destination block (S17), and transfer a response RES indicating that the write operation WOP is completed to the memory controller 100 (S18). The response RES may include switching a ready-busy signal to a ready (READY) state. For convenience of illustration, FIG. 10 illustrates an operation for one weak wordline WWL. In some example embodiments, a series of the operations described in FIG. 10 may be performed for each of the weak wordlines WWL.

As illustrated in FIG. 11, in the external copyback operation, the read data RDT are transferred from the nonvolatile memory device 300 to the memory controller 100, and the corrected data CDT may be transferred from the memory controller 100 to the nonvolatile memory device 300. In this process, the read data RDT and/or the corrected data CDT may be stored in the external DRAM 80. With this configuration and operation, in the external copyback operation, error correction may be performed, but hardware resources of the memory controller 100 may be consumed much.

FIG. 12 is a sequence diagram illustrating an internal copyback operation of a storage device according to example embodiments, and FIG. 13 is a diagram illustrating a data flow according to the internal copyback operation of FIG. 12, according to some example embodiments.

Referring to FIGS. 1, 4, 12, and 13, the reclaim manager RCM may select a source block SBL to be a target of block reclaim as described above (S20). The reclaim manager RCM may transfer a single command CB including a read row address RADD corresponding to a strong wordline SWL of the source block SBL and a write row address WADD corresponding to a wordline of a destination block to the nonvolatile memory device 300 (S21). The nonvolatile memory device (300) may perform a read operation ROP with respect to the read row address RADD of the source block SBL (S22) to store read data RDT in the page buffer circuit 510. Thereafter, the nonvolatile memory device 300 may perform a write operation WOP (S23) to write the read data RDT stored in the page buffer circuit 510 to the write address WADD of the destination block, and transfer a response RES indicating that the write operation WOP is completed to the memory controller 100 (S24). The response RES may include transitioning the ready-busy signal to the ready (READY) state. For convenience of illustration, an operation for one strong wordline SWL is illustrated in FIG. 12. In some example embodiments, a series of the operations described in FIG. 12 may be performed for each of the strong wordlines SWL.

As illustrated in FIG. 13, in the internal copyback operation, the read data RDT read from the source block SBL may not be transferred from the nonvolatile memory device 300 to the memory controller 100, but is moved to and stored in the destination block DBL using the page buffer circuit 510. In this way, in the internal copyback operation, error correction may not be performed, but hardware resources of the memory controller 100 may be saved.

FIG. 14 is a diagram illustrating an example structure of a cell string of a nonvolatile memory device according to example embodiments.

Referring to FIG. 14, to form a cell string CS, a pillar PL may be provided such that the pillar PL extends in the vertical direction D3 perpendicular to an upper surface of a semiconductor substrate SUB. The ground selection line GSL, the wordlines WL, and the string selection lines SSL may each be formed of conductive materials, for example, metal materials, that are parallel to the semiconductor substrate SUB. The pillar PL may penetrate the conductive materials forming the ground selection line GSL, the wordlines WL, and the string selection lines SSL. In addition, the wordlines WL may include a dummy wordline that is not used for data storage. The dummy wordline may be used for various purposes. For example, in a manufacturing process of a cell string CS, the width of the pillar PL or the cross-sectional area parallel to the upper surface of the semiconductor substrate SUB may be formed smaller as the distance from the semiconductor substrate SUB decreases. Accordingly, when the same voltage is applied to the bodies of the ground select transistor GST in FIG. 7, the memory cells MC and the string select transistors SST and the same voltage is applied to the ground selection line GSL, the wordlines WL and the string selection lines SSL, an electric field formed in the memory cell or the ground select transistor GST adjacent to the semiconductor substrate SUB is larger than an electric field formed in a memory cell or the string select transistor SST far from the semiconductor substrate SUB. This characteristic affects a disturbance that occurs during a program operation and/or a read operation. The width of the pillar PL or the cross-sectional area parallel to the upper surface of the semiconductor substrate SUB is not limited to the case as illustrated in FIG. 14. In some example embodiments, the width of the pillar PL or the cross-sectional area parallel to the upper surface of the semiconductor substrate SUB may be formed differently according to the distance from the semiconductor substrate SUB depending on the etching process. In this way, the characteristics of the memory cell may be different depending on the physical position or the height in the vertical direction D3 of the wordline. The pillar PL corresponds to the channel hole of the cell string, and as shown in FIG. 14, the diameter of the cross-sectional area of the channel hole decreases as it goes downward. That is, as shown in FIG. 14, the diameter of the cross-sectional area of the channel hole decreases as a distance from the semiconductor substrate SUB decreases. Therefore, the size of the floating gate of the flash memory cell decreases as it goes downward in the channel hole, and the retention capability of the memory cell decreases. That is, the size of the floating gate of the flash memory cell decreases a distance from the semiconductor substrate SUB in the channel hole decreases. Therefore, the retention capability of the memory cells connected to the wordline WL0 located at the lowest portion of the channel hole may be the smallest, and the retention capability of the memory cells connected to the wordline WLn located at the highest portion of the channel hole may be the largest. On the other hand, the retention capability of the memory cells located at the end of the channel hole may be reduced due to limitations of the manufacturing process, etc. According to the characteristics of such physical structures, the grouping of the aforementioned weak wordlines WWL and the strong wordlines SWL may be performed.

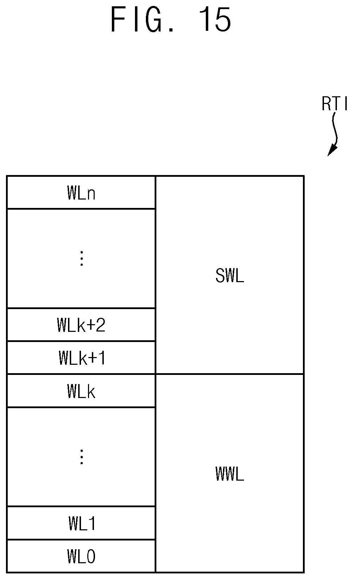

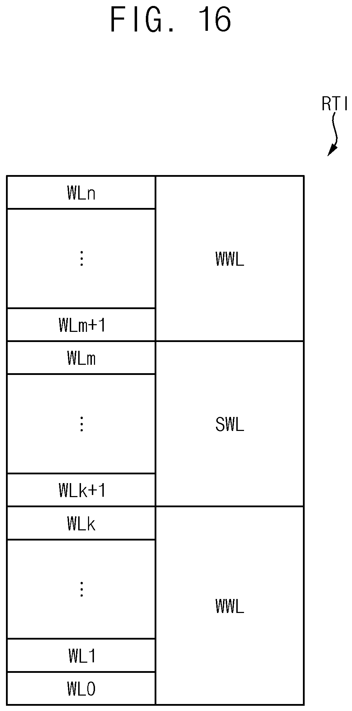

FIGS. 15 and 16 are diagrams illustrating retention characteristic information of a method of a block reclaim in a storage device, according to example embodiments.

In an example embodiment, as illustrated in FIG. 15, wordlines WL0 through WLk arranged at the lower portion bottom of the channel hole may be determined as the weak wordlines WWL, and wordlines WLk+1 through WLn arranged at the upper portion of the channel hole may be determined as the strong wordlines SWL.

In an example embodiment, as illustrated in FIG. 16, wordlines WL0 through WLk and WLm+1 through WLn arranged at the end portions of the channel hole in the vertical direction D3 may be determined as the weak wordlines WWL, and wordlines WLk+1 through WLm arranged at the central portion between the end portions of the channel hole in the vertical direction D3 may be determined as the strong wordlines SWL.

FIG. 17 is a diagram illustrating changing retention characteristic information of a method of a block reclaim in a storage device, according to example embodiments.

Referring to FIG. 17, as the deterioration of the retention characteristic of each memory block increases, the number of weak wordlines WWL may be increased and the number of strong wordlines SWL may be decreased. In an example embodiment, the retention characteristic of the memory block may be expressed by a program-erase count NPE. As the program-erase count NPE of the memory block increases, the deterioration of the retention characteristics of the memory block may increase. For example, as illustrated in FIG. 17, when the program-erase count NPE is less than the reference value No, three wordlines WL0 through WL2 may be determined as the weak wordlines WWL and five wordlines WL3 through WL7 may be determined as strong wordlines SWL. Thereafter, when the program-erase count NPE exceeds the reference value No, five wordlines WL0 through WL4 may be determined as the weak wordlines WWL and three wordlines WL5 through WL7 may be determined as the strong wordlines SWL.

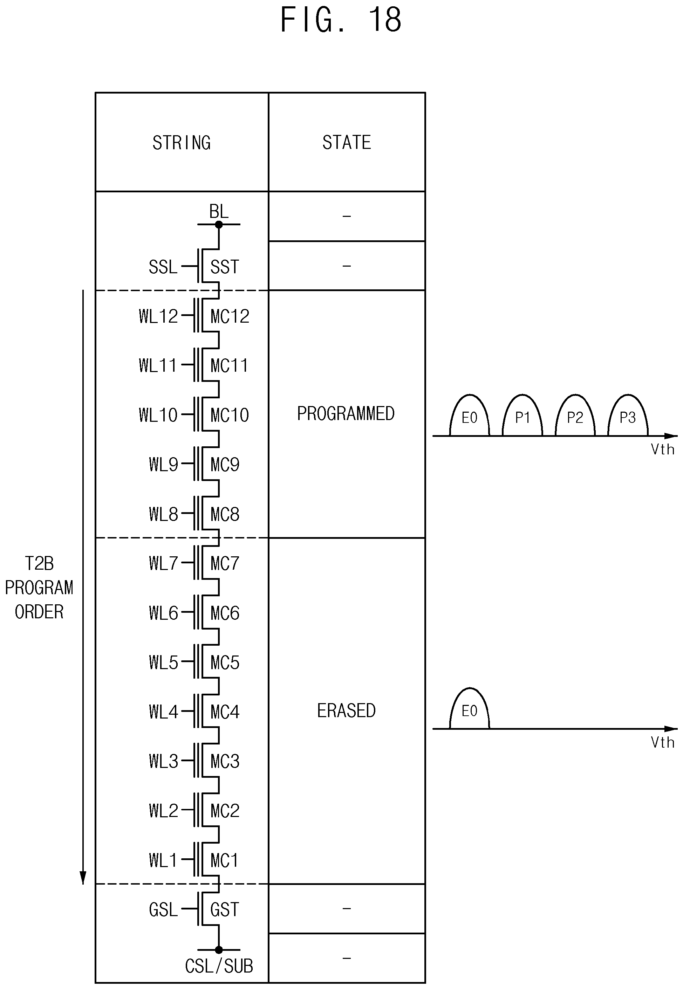

FIG. 18 is a diagram illustrating a program method in a storage device according to example embodiments.

Referring to FIG. 18, according to an operating scenario of the nonvolatile memory device, the write operation or the program operation may be sequentially performed downward from the top wordline. In this case, as the data stored in the memory block increases, the data are filled in the order from top to bottom (T2B).

The memory cells MC1 through MC7 of the erased wordline are in an erased state E0, and the memory cells MC8 through MC12 of the programmed wordline may have the erased state E0 or respective program states P1, P2 and P3 depending on the stored data.

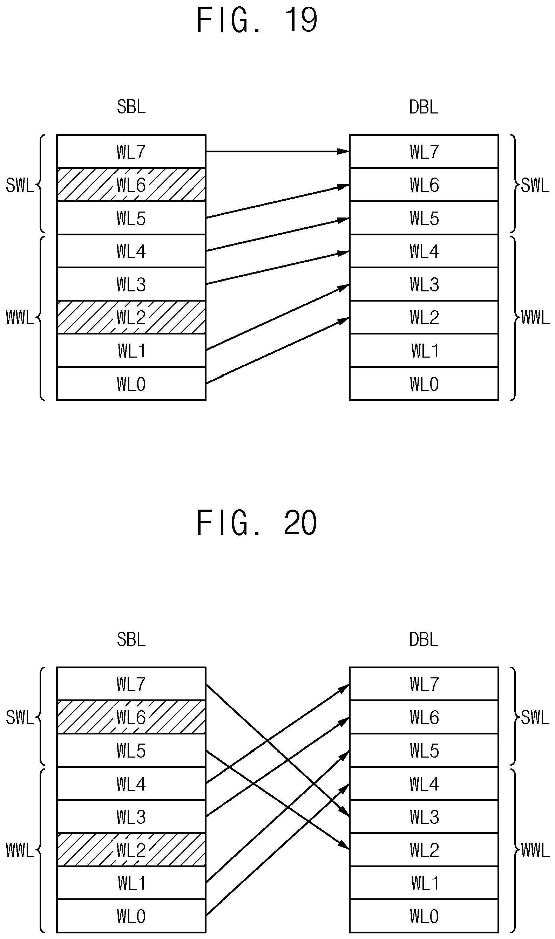

FIGS. 19 and 20 are diagrams illustrating execution order of a method of a block reclaim in the storage device, according to example embodiments.

Referring to FIG. 19, after performing the internal copyback operation with respect to the strong wordlines SWL of the source block SBL, the external copyback operation with respect to the weak wordlines WWL of the source block SBL may be performed. While performing the block reclaim, garbage collection may be performed simultaneously to discard invalid data (hatched portion) stored in the source block SBL and store only valid data stored in the source block SBL in the destination block DBL.

As a result, when the T2B program order of FIG. 18 is adopted, the valid data corresponding to the wordlines WL7, WL5, WL4, WL3, WL1 and WL0 of the source block SBL may be stored in memory cells connected to the wordlines WL7 through WL2 of the destination block DBL.

Referring to FIG. 20, after performing the external copyback operation with respect to the weak wordlines WWL of the source block SBL, the internal copyback operation on the strong wordlines SWL of the source block SBL may be performed. As a result, the read data by the external copyback operation may be stored primarily in the memory cells connected to the strong wordlines SWL of the destination block DBL, and then the read data by the internal copyback operation may be stored in the destination block DBL.

With this configuration and operation, errors may be reduced or prevented from accumulating by reducing or preventing the internal copyback operation being continuously applied to the same data without error correction while the block reclaim is repeated.

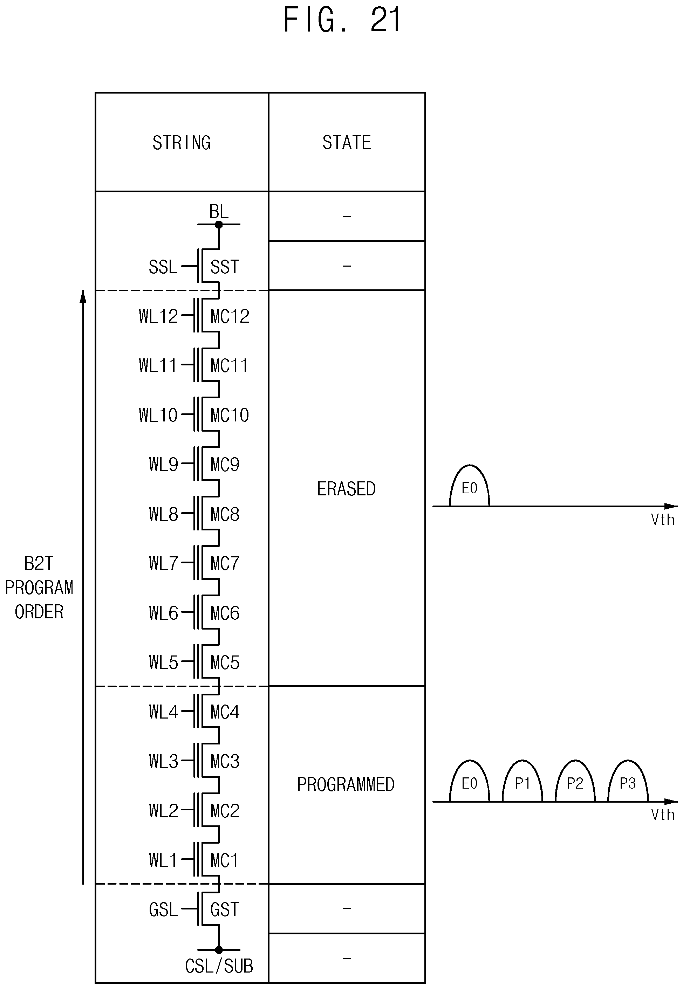

FIG. 21 is a diagram illustrating a program method in a storage device according to example embodiments. The descriptions that are repeated with FIG. 18 may be omitted below for conciseness.

Referring to FIG. 21, according to an operating scenario of a nonvolatile memory device, the write operation or the program operation may be sequentially performed upward from the bottom wordline. In this case, as the data stored in the memory block increases, the data are filled in the order from bottom to top (T2B).

The memory cells MC5 through MC12 of the erased wordline are in the erased state E0, and the memory cells MC1 through MC4 of the programmed wordline may have the erased state E0 or one of the program states P1, P2 and P3 depending on the stored data. Even when the B2T program order of FIG. 21 is applied, execution orders of block reclaim such as FIG. 19 or FIG. 20 may be selectively applied.

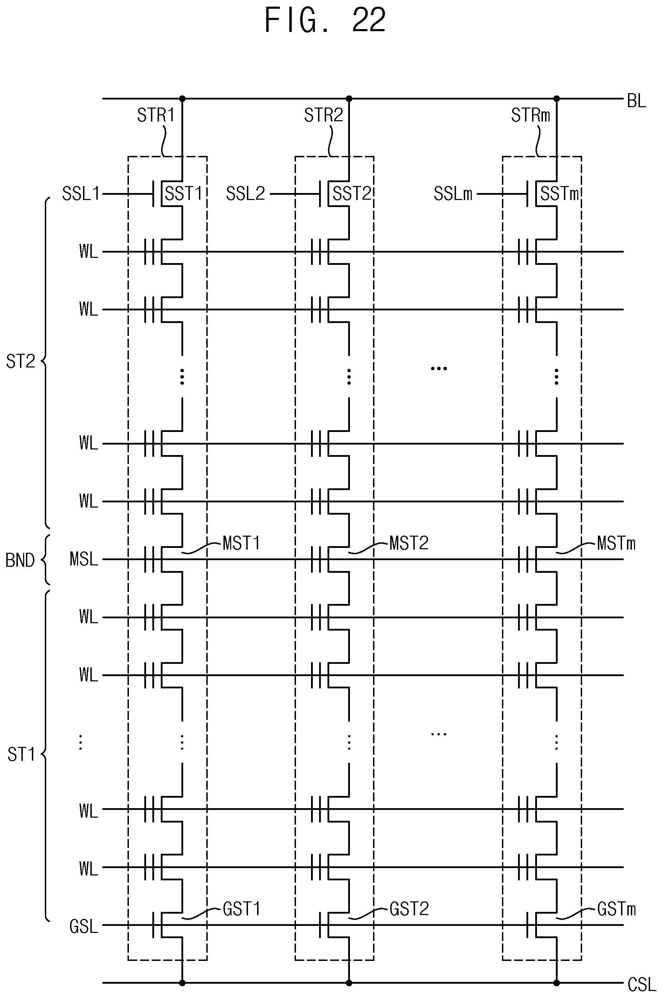

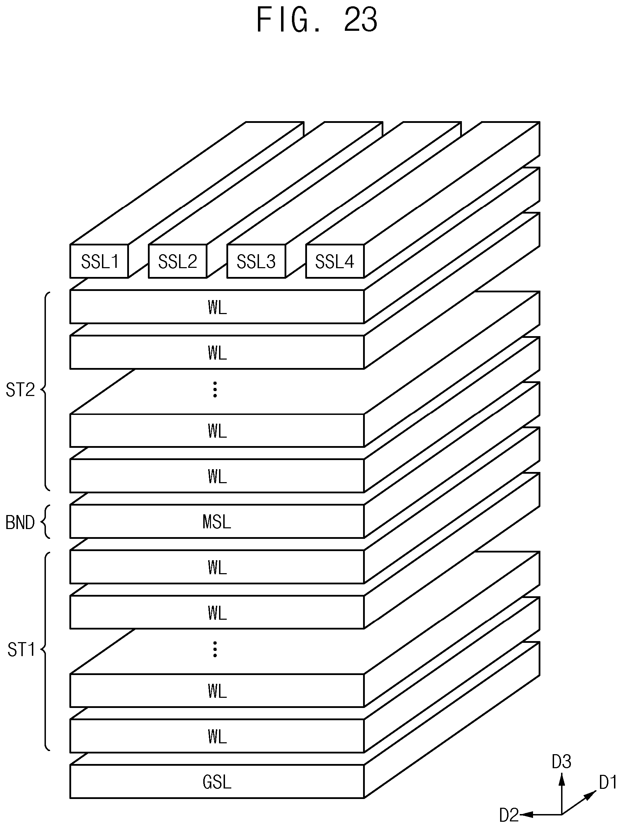

FIG. 22 is a circuit diagram illustrating a structure of a memory cell array included in a nonvolatile memory device, according to example embodiments, and FIG. 23 is a diagram illustrating a memory block corresponding to the structure of FIG. 22, according to example embodiments.

For convenience of illustration and description, FIG. 22 illustrates NAND strings or cell strings STR1 through STRm connected to one bitline BL and one common source line CSL among the cell strings of a memory block but, in some example embodiments, the memory block may have a three-dimensional structure as described with reference to FIGS. 6 and 7.

Referring to FIG. 22, the memory block may include a plurality of cell strings STR1 through STRm connected between the same bitline BL and the common source line CSL. Each of the cell strings STR1 through STRm may include string select transistors SST1 through SSTm controlled by string selection lines SSL1 through SSLm, memory cells controlled by wordlines WL, intermediate switching transistors MST1 through MSTm controlled by an intermediate switching line MSL, and ground select transistors GST1 through GSTm controlled by a ground selection line GSL. Memory cells connected to at least one wordline located at both ends in the vertical direction D3 of the first and second stacks ST1 and ST2 may be dummy cells. Data may not be stored in the dummy cells. In some example embodiments, the dummy cells may be set to store data of a smaller number of bits than other memory cells.

Although FIG. 22 illustrates an example embodiment in which ground selection transistors are connected to the same ground selection line GSL, a number of ground selection transistors may be connected to each of a plurality of ground selection lines. In some example embodiments, the number of ground selection transistors that are connected to each of the ground selection lines may be predetermined.

In an example embodiment, as illustrated in FIG. 23, the boundary layer BND may include one gate line. The one gate line corresponds to the intermediate switching line MSL and may simultaneously switch the intermediate switching transistors MSL1 through MSLm connected thereto. According to example embodiments, the boundary layer BND may include two or more gate lines.

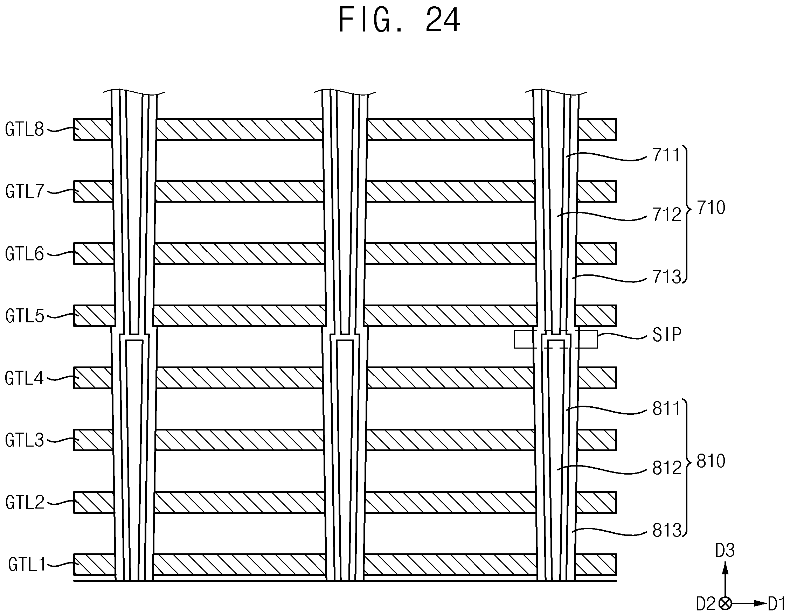

FIG. 24 is a cross-sectional diagram illustrating a boundary layer included in a nonvolatile memory device, according to example embodiments.

Referring to FIG. 24, each channel hole forming each cell string may include a first sub-channel hole 810 and a second sub-channel hole 710. The first sub-channel hole 810 may include a channel film 811, an internal material 812, and an insulating film 813. The second sub-channel hole 710 may include a channel film 711, an internal material 712, and an insulating film 713. The channel film 811 of the first sub-channel hole 810 and the channel film 711 of the second sub-channel hole 710 may be connected through a P-type silicon pad SIP. These multiple sub-channel holes 810 and 710 may be formed using a stopper line GTL5 having an appropriate etching selectivity. For example, to implement the appropriate etching selectivity, the stopper line GTL5 may be formed of polysilicon, and the remaining gate lines GTL1 through GTL4 and GTL6 through GTL8 may be formed of a metal such as tungsten. Depending on the doping concentration of the polysilicon, the resistance value of the stopper line GTL5 may be significantly greater than the resistance values of the remaining gate lines GTL1 through GTL4 and GTL6 through GTL8 by about 6 times.

The boundary layer between the stacks described above may correspond to the stopper layer GTL5 for stepwise forming a plurality of sub-channel holes forming the channel holes of the cell string. The cells of the stopper layer may not be suitable for storing data, and the stopper layer may be used as a boundary layer for forming intermediate switching transistors according to example embodiments. One or more gate line layers vertically adjacent to the stopper layer GTL5 in the vertical direction D3 may be further included in the boundary layer. The intermediate switching transistors formed in the boundary layer may be implemented as a cell type or a transistor type. Here, the cell type refers to a cell including a floating gate, such as a flash memory cell, and the transistor type refers to a cell in which the floating gate is omitted.

The example in which each channel hole includes two sub-channel holes is described referring to FIG. 24, but example embodiments are not limited thereto. According to example embodiments, each channel hole may include three or more sub-channel holes that are stacked in the vertical direction D3.

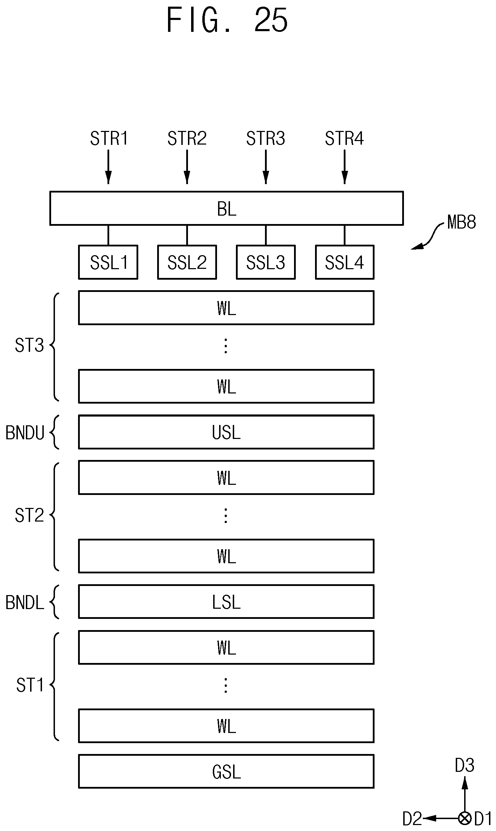

FIG. 25 is a diagram illustrating a memory block included in a nonvolatile memory device, according to example embodiments.

Referring to FIG. 25, the above-described boundary layer may include a lower boundary layer BNDL and an upper boundary layer BNDU. The memory block MB8 includes a first stack ST1 disposed below the lower boundary layer BNDL, a second stack ST2 disposed between the lower boundary layer BNDL and the upper boundary layer BNDU, and a third stack ST3 disposed above the upper boundary layer BNDU.

The above-described intermediate switching transistors include a plurality of lower switching transistors disposed on the lower boundary layer BNDL and connected to the lower switching line LSL, and a plurality of upper switching transistors disposed on the upper boundary layer BNDU and connected to the upper switching line USL.

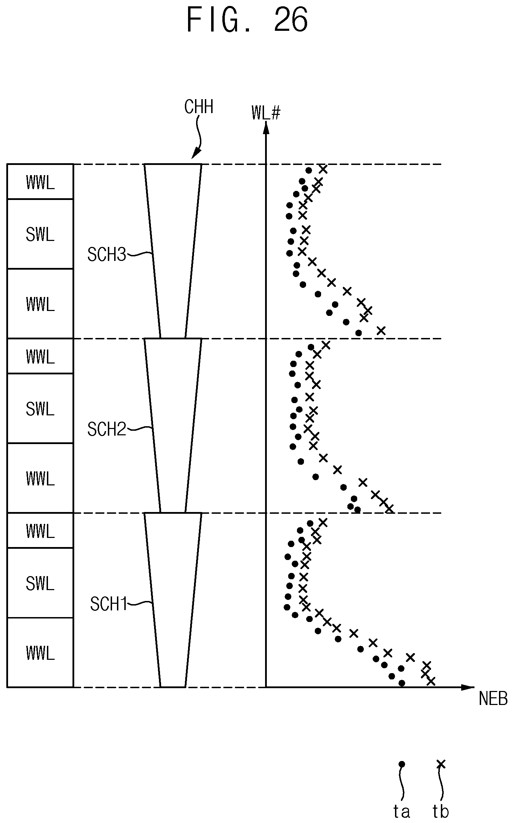

FIG. 26 is a diagram illustrating a retention characteristic and retention characteristic information of a nonvolatile memory device, according to example embodiments.

FIG. 26 illustrates an example in which each channel hole CHH includes three sub-channel holes SCH1, SCH2 and SCH3 stacked in the vertical direction D3. In FIG. 26, WL# represents a wordline number, and a smaller wordline number WL# corresponds to a wordline located at the lower portion of the channel hole CHH. NEB represents a number of error bits, that is, the error bit number, and ta and tb represent elapsed times after a write operation is completed for a memory block. The second elapsed time tb is greater than the first elapsed time ta, and the error bit number NEB increases as the elapsed time increases.

As shown in FIG. 26, for each of the sub-channel holes SCH1, SCH2 and SCH3, the error bit number NEB at the bottom of the sub-channel hole increases. The error bit number NEB at the boundary portions of the sub-channel holes SCH1, SCH2 and SCH3 increases more than the central portion. Considering the retention characteristics due to such a physical structure, the wordlines of each sub-channel hole of the plurality of sub-channel holes SCH1, SCH2 and SCH3 may be grouped into weak wordlines WWL and strong wordlines SWL.

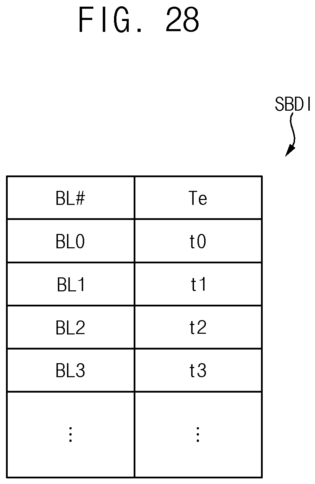

FIG. 27 is a flowchart illustrating determining a source block of a method of a block reclaim in a storage device, according to example embodiments, and FIG. 28 is a diagram illustrating source block determination information corresponding to the method of FIG. 27, according to example embodiments.

Referring to FIGS. 1, 27, and 28, the reclaim manager RCM may monitor an elapsed time Te that is elapsed after the completion of the write operation for each memory block BLi of the plurality of memory blocks (S51). The reclaim manager RCM may store and manage source block determination information SBDI including the elapsed times t0 through t3 monitored for each of the memory blocks BL0 though BL3 as illustrated in FIG. 28.

The reclaim manager RCM may determine whether the elapsed time Te is greater than or equal to a reference time Tr (S52). If the elapsed time Te is greater than or equal to the reference time Tr (S52: YES), the reclaim manager RCM may determine the corresponding memory block BLi as a source block SBL (S53). If the elapsed time Te is less than the reference time Tr (S52: NO), the reclaim manager RCM may return to monitoring in S51.

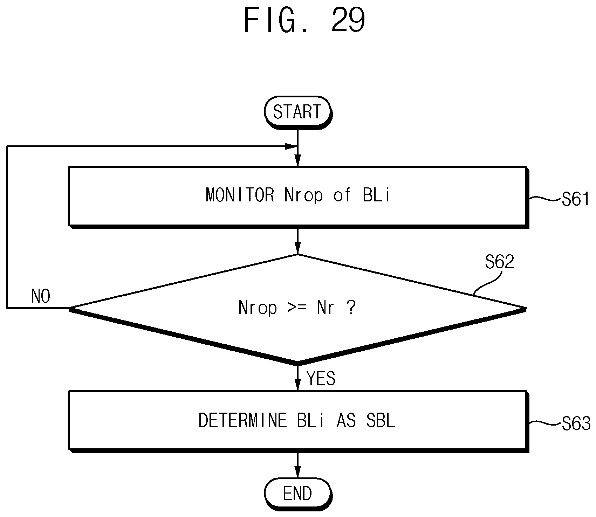

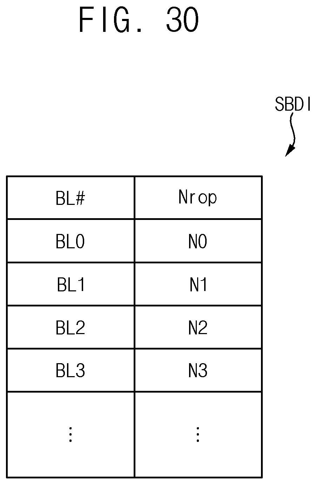

FIG. 29 is a flowchart illustrating determining a source block of a method of a block reclaim in a storage device, according to example embodiments, and FIG. 30 is a diagram illustrating source block determination information corresponding to the method of FIG. 29, according to example embodiments.

Referring to FIGS. 1, 29, and 30, the reclaim manager RCM may monitor a read number Nrop that a read operation has been performed for each memory block BLi of the plurality of memory blocks (S61). The reclaim manager RCM may store and manage source block determination information SBDI including the read numbers N0 through N3 monitored for each of the memory blocks BL0 through BL3 as shown in FIG. 30.

The reclaim manager RCM may determine whether the read number Nrop is greater than or equal to a reference number Nr (S62). If the read number Nrop that the read operation is performed is greater than or equal to the reference number Nr (S62: YES), the reclaim manager RCM may determine the corresponding memory block BLi as a source block (SBL) (S63). If the read number Nrop that the read operation is performed is less than the reference number Nr (S62: NO), the reclaim manager RCM may return to monitoring in S61.

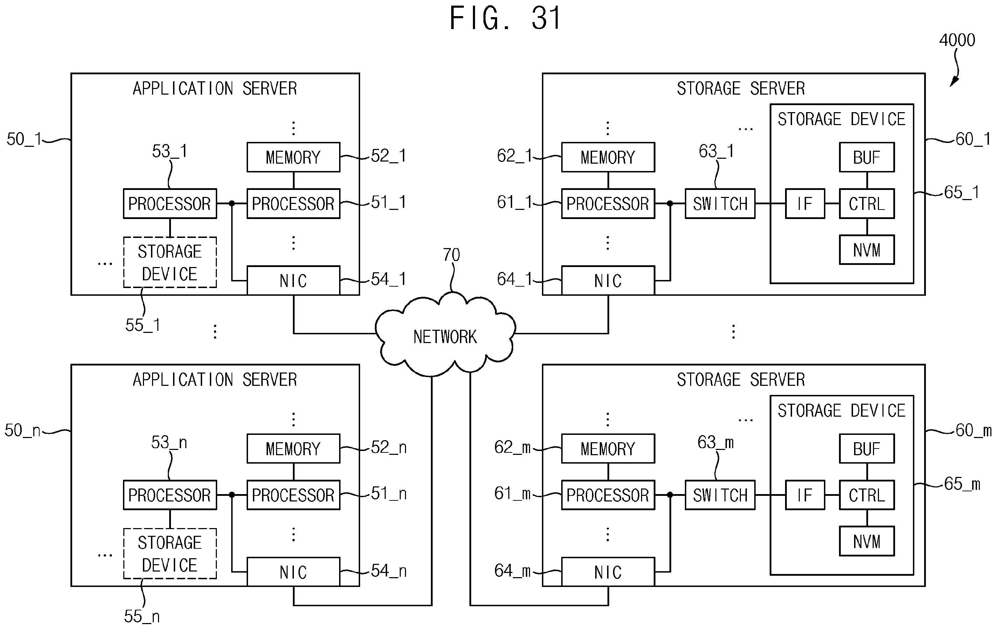

FIG. 31 is a block diagram illustrating a data center including a storage device according to example embodiments.

In some example embodiments, the storage device described above with reference to FIGS. 1 through 30 may serve as an application server and/or a storage server and may be included in a data center 4000.

Referring to FIG. 31, the data center 4000 may collect various pieces of data and provide services and be also referred to as a data storage center. For example, the data center 4000 may be a system configured to operate a search engine and a database or a computing system used by companies, such as banks, or government agencies. As shown in FIG. 31, the data center 4000 may include application servers 50_1 to 50_n and storage servers 60_1 to 60_m (where, each of m and n is an integer more than 1). The number n of application servers 50_1 to 50_n and the number m of storage servers 60_1 to 60_m may be variously selected according to example embodiments. In some example embodiments, the number n of application servers 50_1 to 50_n may be different from the number m of storage servers 60_1 to 60_m.

The application servers 50_1 to 50_n may include any one or any combination of processors 51_1 to 51_n, memories 52_1 to 52_n, switches 53_1 to 53_n, network interface controllers (NICs) 54_1 to 54_n, and storage devices 55_1 to 55_n. In some example embodiments, the storage devices 55_1 to 55_n may be the storage device 10 described above with respect to FIGS. 1-30. The processors 51_1 to 51_n may control all operations of the application servers 50_1 to 50_n, access the memories 52_1 to 52_n, and execute instructions and/or data loaded in the memories 52_1 to 52_n. Non-limiting examples of the memories 52_1 to 52_n may include DDR SDRAM, a high-bandwidth memory (HBM), a hybrid memory cube (HMC), a dual in-line memory module (DIMM), a Optane DIMM, and/or a nonvolatile DIMM (NVDIIMM).

According to example embodiments, the numbers of processors and memories included in the application servers 50_1 to 50_n may be variously selected according to example embodiments. In some example embodiments, the processors 51_1 to 51_n and the memories 52_1 to 52_n may provide processor-memory pairs. In some example embodiments, the number of processors 51_1 to 51_n may be different from the number of memories 52_1 to 52_n. The processors 51_1 to 51_n may include a single core processor or a multi-core processor. In some example embodiments, as illustrated with a dashed line in FIG. 31, the storage devices 55_1 to 55_n may be omitted from the application servers 50_1 to 50_n. The number of storage devices 55_1 to 55_n included in the storage servers 50_1 to 50_n may be variously selected according to example embodiments. The processors 51_1 to 51_n, the memories 52_1 to 52_n, the switches 53_1 to 53_n, the NICs 54_1 to 54_n, and/or the storage devices 55_1 to 55_n may communicate with each other through a link described above with reference to the drawings.

The storage servers 60_1 to 60_m may include any one or any combination of processors 61_1 to 61_m, memories 62_1 to 62_m, switches 63_1 to 63_m, network interface controllers (NICs) 64_1 to 64_n, and storage devices 65_1 to 65_m. In some example embodiments, the storage devices 65_1 to 65_m may be the storage device 10 described above with respect to FIGS. 1-30. The processors 61_1 to 61_m and the memories 62_1 to 62_m may operate similar to the processors 51_1 to 51_n and the memories 52_1 to 52_n of the application servers 50_1 to 50_n described above.

The application servers 50_1 to 50_n may communicate with the storage servers 60_1 to 60_m through a network 70. In some example embodiments, the network 70 may be implemented using a fiber channel (FC) or Ethernet. The FC may be a medium used for relatively high-speed data transfer. An optical switch that provides high performance and high availability may be used as the FC. The storage servers 60_1 to 60_m may be provided as file storages, block storages, or object storages according to an access method of the network 70.

In some example embodiments, the network 70 may be a storage-only network, such as a storage area network (SAN). For example, the SAN may be an FC-SAN, which may use an FC network and be implemented using an FC Protocol (FCP). In another case, the SAN may be an Internet protocol (IP)-SAN, which uses a transmission control protocol/Internet protocol (TCP/IP) network and is implemented according to an SCSI over TCP/IP or Internet SCSI (iSCSI) protocol. In some example embodiments, the network 70 may be a general network, such as a TCP/IP network. For example, the network 70 may be implemented according to a protocol, such as FC over Ethernet (FCoE), network attached storage (NAS), nonvolatile memory express (NVMe) over fabrics (NVMe-oF).

The application server 50_1 and the storage server 60_1 will mainly be described, but it may be noted that a description of the application server 50_1 may be also applied to another application server (e.g., 50_n), and a description of the storage server 60_1 may be also applied to another storage server (e.g., 60_m).

The application server 50_1 may store data, which is requested to be stored by a user or a client, in one of the storage servers 60_1 to 60_m through the network 70. In some example embodiments, the application server 50_1 may obtain data, which is requested to be read by the user or the client, from one of the storage servers 60_1 to 60_m through the network 70. For example, the application server 50_1 may be implemented using a web server or a database management system (DBMS).

The application server 50_1 may access the memory 52_n and/or the storage device 55_n included in another application server 50_n, through the network 70, and/or access the memories 62_1 to 62_m and/or the storage devices 65_1 to 65_m included in the storage servers 60_1 to 60_m, through the network 70. Accordingly, the application server 50_1 may perform various operations on data stored in the application servers 50_1 to 50_n and/or the storage servers 60_1 to 60_m. For example, the application server 50_1 may execute an instruction to migrate or copy data between the application servers 50_1 to 50_n and/or the storage servers 60_1 to 60_m. In this case, the data may be migrated from the storage devices 65_1 to 65_m of the storage servers 60_1 to 60_m to the memories 52_1 to 52_n of the application servers 50_1 to 50_n through the memories 62_1 to 62_m of the storage servers 60_1 to 60_m or directly. In some example embodiments, the data migrated through the network 70 may be encrypted data for security or privacy.

In the storage server 60_1, an interface IF may provide physical connection between the processor 61_1 and a controller CTRL and physical connection between the NIC 64_1 and the controller CTRL. For example, the interface IF may be implemented using a direct attached storage (DAS) method in which the storage device 65_1 is directly connected to a dedicated cable. For example, the interface IF may be implemented using various interface methods, such as advanced technology attachment (ATA), serial ATA (SATA), external SATA (e-SATA), small computer small interface (SCSI), serial attached SCSI (SAS), PCI, PCIe, NVMe, IEEE 1394, a universal serial bus (USB), a secure digital (SD) card, a multi-media card (MMC), an embedded MMC (eMMC), a UFS, an embedded UFS (eUFS), and/or a compact flash (CF) card interface.

In the storage server 60_1, the switch 63_1 may selectively connect the processor 61_1 to the storage device 65_1 or selectively connect the NIC 64_1 to the storage device 65_1 based on the control of the processor 61_1.

In some example embodiments, the network interface controller (NIC) 64_1 may include a network interface card and a network adaptor. The NIC 54_1 may be connected to the network 70 through a wired interface, a wireless interface, a Bluetooth interface, or an optical interface. The NIC 54_1 may include an internal memory, a digital signal processor (DSP), and a host bus interface and be connected to the processor 61_1 and/or the switch 63_1 through the host bus interface. In some example embodiments, the NIC 64_1 may be integrated with any one or any combination of the processor 61_1, the switch 63_1, and the storage device 65_1.

In the application servers 50_1 to 50_n or the storage servers 60_1 to 60_m, the processors 51_1 to 51_m and 61_1 to 61_n may transmit commands to the storage devices 55_1 to 55_n and 65_1 to 65_m or the memories 52_1 to 52_n and 62_1 to 62_m and program or read data. In this case, the data may be data of which an error is corrected by an error correction code (ECC) engine. The data may be data processed with data bus inversion (DBI) or data masking (DM) and include cyclic redundancy Code (CRC) information. The data may be encrypted data for security or privacy.

In response to read commands received from the processors 51_1 to 51_m and 61_1 to 61_n, the storage devices 55_1 to 55_n and 65_1 to 65_m may transmit control signals and command/address signals to a nonvolatile memory device (e.g., a NAND flash memory device) NVM. Accordingly, when data is read from the nonvolatile memory device NVM, a read enable signal may be input as a data output control signal to output the data to a DQ bus. A data strobe signal may be generated using the read enable signal. The command and the address signal may be latched according to a rising edge or falling edge of a write enable signal.

The controller CTRL may control all operations of the storage device 65_1. In example embodiments, the controller CTRL may include static RAM (SRAM). The controller CTRL may write data to the nonvolatile memory device NVM in response to a write command or read data from the nonvolatile memory device NVM in response to a read command. For example, the write command and/or the read command may be generated based on a request provided from a host (e.g., the processor 61_1 of the storage server 60_1, the processor 61_m of another storage server 60_m, or the processors 51_1 to 51_n of the application servers 50_1 to 50_n). A buffer BUF may temporarily store (or buffer) data to be written to the nonvolatile memory device NVM or data read from the nonvolatile memory device NVM. In some example embodiments, the buffer BUF may include DRAM. The buffer BUF may store metadata. The metadata may refer to user data or data generated by the controller CTRL to manage the nonvolatile memory device NVM. The storage device 65_1 may include a secure element (SE) for security or privacy.

FIG. 32 is a cross-section diagram illustrating a nonvolatile memory device according to example embodiments.

Referring to FIG. 32, the memory device 5000 may have a chip-to-chip (C2C) structure. At least one upper chip including a cell region and a lower chip including a peripheral circuit region PREG may be manufactured separately, and then, the at least one upper chip and the lower chip may be connected to each other by a bonding method to realize the C2C structure. For example, the bonding method may refer to a method of electrically and/or physically connecting a bonding metal pattern formed in an uppermost metal layer of the upper chip to a bonding metal pattern formed in an uppermost metal layer of the lower chip. For example, in a case in which the bonding metal patterns are formed of copper (Cu), the bonding method may be a Cu-Cu bonding method. Alternatively or additionally, the bonding metal patterns may be formed of other metals including, but not being limited to, aluminum (Al) or tungsten (W).

The memory device 5000 may include the at least one upper chip including the cell region. For example, as shown in FIG. 32, the memory device 5000 may include two upper chips. However, the number of the upper chips is not limited thereto. In the case in which the memory device 5000 includes the two upper chips, a first upper chip that may include a first cell region CREG1, a second upper chip that may include a second cell region CREG2 and the lower chip that may include the peripheral circuit region PREG, may be manufactured separately. Subsequently, the first upper chip, the second upper chip and the lower chip may be connected to each other by the bonding method to manufacture the memory device 5000, for example. In some example embodiments, the first upper chip may be turned over and then may be connected to the lower chip by the bonding method, and the second upper chip may also be turned over and then may be connected to the first upper chip by the bonding method. Hereinafter, upper and lower portions of each of the first and second upper chips will be defined based on before each of the first and second upper chips is turned over. In other words, an upper portion of the lower chip may mean an upper portion defined based on a +Z-axis direction, and the upper portion of each of the first and second upper chips may mean an upper portion defined based on a -Z-axis direction in FIG. 32. However, the present disclosure is not limited in this regard. For example, in some example embodiments, one of the first upper chip and the second upper chip may be turned over and then may be connected to a corresponding chip by the bonding method.

Each of the peripheral circuit region PREG and the first and second cell regions CREG1 and CREG2 of the memory device 5000 may include an external pad bonding region PA, a wordline bonding region WLBA, and a bitline bonding region BLBA.

The peripheral circuit region PREG may include a first substrate 5210 and a plurality of circuit elements (e.g., first circuit element 5220a, second circuit element 5220b, and third circuit element 5220c) formed on the first substrate 5210. An interlayer insulating layer 5215 including one or more insulating layers may be provided on the plurality of circuit elements 5220a, 5220b and 5220c, and a plurality of metal lines electrically connected to the plurality of circuit elements 5220a, 5220b and 5220c may be provided in the interlayer insulating layer 5215. For example, the plurality of metal lines may include first metal lines 5230a, 5230b and 5230c connected to the plurality of circuit elements 5220a, 5220b and 5220c, and second metal lines 5240a, 5240b and 5240c formed on the first metal lines 5230a, 5230b and 5230c. The plurality of metal lines may be formed of at least one of various conductive materials. In some example embodiments, the first metal lines 5230a, 5230b and 5230c may be formed of tungsten having a relatively high electrical resistivity, and the second metal lines 5240a, 5240b and 5240c may be formed of copper having a relatively low electrical resistivity.

The first metal lines 5230a, 5230b and 5230c and the second metal lines 5240a, 5240b and 5240c are illustrated and described in the present example embodiments. However, the present disclosure is not limited in this regard. For example, in some example embodiments, at least one or more additional metal lines may further be formed on the second metal lines 5240a, 5240b and 5240c. In this case, the second metal lines 5240a, 5240b and 5240c may be formed of aluminum, and at least some of the additional metal lines formed on the second metal lines 5240a, 5240b and 5240c may be formed of copper having an electrical resistivity lower than that of aluminum of the second metal lines 5240a, 5240b and 5240c.

The interlayer insulating layer 5215 may be disposed on the first substrate 5210 and may include an insulating material such as silicon oxide and/or silicon nitride.

Each of the first and second cell regions CREG1 and CREG2 may include at least one memory block. The first cell region CREG1 may include a second substrate 5310 and a common source line 5320. A plurality of wordlines 5330 (e.g., 5331 to 5338) may be stacked on the second substrate 5310 in a direction (e.g., the Z-axis direction) perpendicular to a top surface of the second substrate 5310. String selection lines and a ground selection line may be disposed on and under the wordlines 5330, and the plurality of wordlines 5330 may be disposed between the string selection lines and the ground selection line. Alternatively or additionally, the second cell region CREG2 may include a third substrate 5410 and a common source line 5420, and a plurality of wordlines 5430 (e.g., 5431 to 5438) may be stacked on the third substrate 5410 in a direction (e.g., the Z-axis direction) perpendicular to a top surface of the third substrate 5410. Each of the second substrate 5310 and the third substrate 5410 may be formed of at least one of various materials, such as, but not limited to, a silicon substrate, a silicon-germanium substrate, a germanium substrate, or a substrate having a single-crystalline epitaxial layer grown on a single-crystalline silicon substrate. A plurality of channel structures CH may be formed in each of the first and second cell regions CREG1 and CREG2.

In some example embodiments, as illustrated in a region 'A1', the channel structure CH may be provided in the bitline bonding region BLBA and may extend in the direction perpendicular to the top surface of the second substrate 5310 to penetrate the wordlines 5330, the string selection lines, and the ground selection line. The channel structure CH may include a data storage layer, a channel layer, and a filling insulation layer. The channel layer may be electrically connected to a first metal line 5350c and a second metal line 5360c in the bitline bonding region BLBA. For example, the second metal line 5360c may be a bitline and may be connected to the channel structure CH through the first metal line 5350c. The bitline 5360c may extend in a first direction (e.g., a Y-axis direction) parallel to the top surface of the second substrate 5310.

In some example embodiments, as illustrated in a region 'A2', the channel structure CH may include a lower channel LCH and an upper channel UCH, which may be connected to each other. For example, the channel structure CH may be formed by a process of forming the lower channel LCH and a process of forming the upper channel UCH. The lower channel LCH may extend in the direction perpendicular to the top surface of the second substrate 5310 to penetrate the common source line 5320 and lower wordlines 5331 and 5332. The lower channel LCH may include a data storage layer, a channel layer, and a filling insulation layer and may be connected to the upper channel UCH. The upper channel UCH may penetrate upper wordlines 5333 to 5338. The upper channel UCH may include a data storage layer, a channel layer, and a filling insulation layer, and the channel layer of the upper channel UCH may be electrically connected to the first metal line 5350c and the second metal line 5360c. As a length of a channel increases, due to characteristics of manufacturing processes, it may be difficult to form a channel having a substantially uniform width. The memory device 5000, according to the present disclosure, may include a channel having improved width uniformity due to the lower channel LCH and the upper channel UCH which are formed by the processes performed sequentially.

In the case in which the channel structure CH includes the lower channel LCH and the upper channel UCH as illustrated in the region 'A2', a wordline located near to a boundary between the lower channel LCH and the upper channel UCH may be a dummy wordline. For example, the wordlines 5332 and 5333 adjacent to the boundary between the lower channel LCH and the upper channel UCH may be the dummy wordlines. In this case, data may not be stored in memory cells connected to the dummy wordline. Alternatively or additionally, the number of pages corresponding to the memory cells connected to the dummy wordline may be less than the number of pages corresponding to the memory cells connected to a general wordline. A level of a voltage applied to the dummy wordline may be different from a level of a voltage applied to the general wordline, and thus, it may be possible to reduce an influence of a non-uniform channel width between the lower and upper channels LCH and UCH on an operation of the memory device.

In some example embodiments, the number of the lower wordlines 5331 and 5332 penetrated by the lower channel LCH may be less than the number of the upper wordlines 5333 to 5338 penetrated by the upper channel UCH in the region 'A2'. However, the present disclosure is not limited in this regard. For example, in some example embodiments, the number of the lower wordlines penetrated by the lower channel LCH may be equal to or more than the number of the upper wordlines penetrated by the upper channel UCH. Alternatively or additionally, structural features and connection relation of the channel structure CH disposed in the second cell region CREG2 may be substantially the same as those of the channel structure CH disposed in the first cell region CREG1.

In the bitline bonding region BLBA, a first through-electrode THV1 may be provided in the first cell region CREG1, and a second through-electrode THV2 may be provided in the second cell region CREG2. As illustrated in FIG. 32, the first through-electrode THV1 may penetrate the common source line 5320 and the plurality of wordlines 5330. In some example embodiments, the first through-electrode THV1 may further penetrate the second substrate 5310. The first through-electrode THV1 may include a conductive material. Alternatively or additionally, the first through-electrode THV1 may include a conductive material surrounded by an insulating material. The second through-electrode THV2 may have the same shape and structure as the first through-electrode THV1.

In some example embodiments, the first through-electrode THV1 and the second through-electrode THV2 may be electrically connected to each other through a first through-metal pattern 5372d and a second through-metal pattern 5472d. The first through-metal pattern 5372d may be formed at a bottom end of the first upper chip including the first cell region CREG1, and the second through-metal pattern 5472d may be formed at a top end of the second upper chip including the second cell region CREG2. The first through-electrode THV1 may be electrically connected to the first metal line 5350c and the second metal line 5360c. A lower via 5371d may be formed between the first through-electrode THV1 and the first through-metal pattern 5372d, and an upper via 5471d may be formed between the second through-electrode THV2 and the second through-metal pattern 5472d. The first through-metal pattern 5372d and the second through-metal pattern 5472d may be connected to each other by the bonding method.

In some example embodiments, in the bitline bonding region BLBA, an upper metal pattern 5252 may be formed in an uppermost metal layer of the peripheral circuit region PERI, and an upper metal pattern 5392 having the same shape as the upper metal pattern 5252 may be formed in an uppermost metal layer of the first cell region CREG1. The upper metal pattern 5392 of the first cell region CREG1 and the upper metal pattern 5252 of the peripheral circuit region PREG may be electrically connected to each other by the bonding method. In the bitline bonding region BLBA, the bitline 5360c may be electrically connected to a page buffer included in the peripheral circuit region PERI. For example, some of the circuit elements 5220c of the peripheral circuit region PREG may constitute the page buffer, and the bitline 5360c may be electrically connected to the circuit elements 5220c constituting the page buffer through an upper bonding metal pattern 5370c of the first cell region CREG1 and an upper bonding metal pattern 5270c of the peripheral circuit region PERI.

Continuing to refer to FIG. 32, in the wordline bonding region WLBA, the wordlines 5330 of the first cell region CREG1 may extend in a second direction (e.g., an X-axis direction) parallel to the top surface of the second substrate 5310 and may be connected to a plurality of cell contact plugs 5340 (e.g., 5341 to 5347). First metal lines 5350b and second metal lines 5360b may be sequentially connected onto the cell contact plugs 5340 connected to the wordlines 5330. In the wordline bonding region WLBA, the cell contact plugs 5340 may be connected to the peripheral circuit region PREG through upper bonding metal patterns 5370b of the first cell region CREG1 and upper bonding metal patterns 5270b of the peripheral circuit region PERI.

The cell contact plugs 5340 may be electrically connected to a row decoder included in the peripheral circuit region PERI. For example, some of the circuit elements 5220b of the peripheral circuit region PREG may constitute the row decoder, and the cell contact plugs 5340 may be electrically connected to the circuit elements 5220b constituting the row decoder through the upper bonding metal patterns 5370b of the first cell region CREG1 and the upper bonding metal patterns 5270b of the peripheral circuit region PERI. In some example embodiments, an operating voltage of the circuit elements 5220b constituting the row decoder may be different from an operating voltage of the circuit elements 5220c constituting the page buffer. For example, the operating voltage of the circuit elements 5220c constituting the page buffer may be greater than the operating voltage of the circuit elements 5220b constituting the row decoder.

In some example embodiments, in the wordline bonding region WLBA, the wordlines 5430 of the second cell region CREG2 may extend in the second direction (e.g., the X-axis direction) parallel to the top surface of the third substrate 5410 and may be connected to a plurality of cell contact plugs 5440 (e.g., 5441 to 5447). The cell contact plugs 5440 may be connected to the peripheral circuit region PREG through an upper metal pattern of the second cell region CREG2 and lower and upper metal patterns and a cell contact plug 5348 of the first cell region CREG1.

In the wordline bonding region WLBA, the upper bonding metal patterns 5370b may be formed in the first cell region CREG1, and the upper bonding metal patterns 5270b may be formed in the peripheral circuit region PERI. The upper bonding metal patterns 5370b of the first cell region CREG1 and the upper bonding metal patterns 5270b of the peripheral circuit region PREG may be electrically connected to each other by the bonding method. The upper bonding metal patterns 5370b and the upper bonding metal patterns 5270b may be formed of at least one metal including, but not limited to, aluminum, copper, and tungsten.

In the external pad bonding region PA, a lower metal pattern 5371e may be formed in a lower portion of the first cell region CREG1, and an upper metal pattern 5472a may be formed in an upper portion of the second cell region CREG2. The lower metal pattern 5371e of the first cell region CREG1 and the upper metal pattern 5472a of the second cell region CREG2 may be connected to each other by the bonding method in the external pad bonding region PA. In some example embodiments, an upper metal pattern 5372a may be formed in an upper portion of the first cell region CREG1, and an upper metal pattern 5272a may be formed in an upper portion of the peripheral circuit region PERI. The upper metal pattern 5372a of the first cell region CREG1 and the upper metal pattern 5272a of the peripheral circuit region PREG may be connected to each other by the bonding method.

Common source line contact plugs 5380 and 5480 may be disposed in the external pad bonding region PA. The common source line contact plugs 5380 and 5480 may be formed of a conductive material such as a metal, a metal compound, and/or doped polysilicon. The common source line contact plug 5380 of the first cell region CREG1 may be electrically connected to the common source line 5320, and the common source line contact plug 5480 of the second cell region CREG2 may be electrically connected to the common source line 5420. A first metal line 5350a and a second metal line 5360a may be sequentially stacked on the common source line contact plug 5380 of the first cell region CREG1, and a first metal line 5450a and a second metal line 5460a may be sequentially stacked on the common source line contact plug 5480 of the second cell region CREG2.

Input/output pads 5205, 5405 and 5406 may be disposed in the external pad bonding region PA. As shown in FIG. 32, a lower insulating layer 5201 may cover a bottom surface of the first substrate 5210, and a first input/output pad 5205 may be formed on the lower insulating layer 5201. The first input/output pad 5205 may be connected to at least one of a plurality of the circuit elements 5220a disposed in the peripheral circuit region PREG through a first input/output contact plug 5203 and may be separated from the first substrate 5210 by the lower insulating layer 5201. Alternatively or additionally, a side insulating layer may be disposed between the first input/output contact plug 5203 and the first substrate 5210 to electrically isolate the first input/output contact plug 5203 from the first substrate 5210.

An upper insulating layer 5401 covering a top surface of the third substrate 5410 may be formed on the third substrate 5410. A second input/output pad 5405 and/or a third input/output pad 5406 may be disposed on the upper insulating layer 5401. The second input/output pad 5405 may be connected to at least one of the plurality of circuit elements 5220a disposed in the peripheral circuit region PREG through second input/output contact plugs 5403 and 5303, and the third input/output pad 5406 may be connected to at least one of the plurality of circuit elements 5220a disposed in the peripheral circuit region PREG through third input/output contact plugs 5404 and 5304.

In some example embodiments, the third substrate 5410 may not be disposed in a region in which the input/output contact plug is disposed. For example, as illustrated in a region 'B', the third input/output contact plug 5404 may be separated from the third substrate 5410 in a direction parallel to the top surface of the third substrate 5410 and may penetrate an interlayer insulating layer 5415 of the second cell region CREG2 so as to be connected to the third input/output pad 5406. **In** this case, the third input/output contact plug 5404 may be formed by at least one of various processes.

**In** some example embodiments, as illustrated in a region 'B1', the third input/output contact plug 5404 may extend in a third direction (e.g., the Z-axis direction), and a diameter of the third input/output contact plug 5404 may become progressively greater (e.g., wider) toward the upper insulating layer 5401. **In** other words, a diameter of the channel structure CH described in the region 'A1' may become progressively less (e.g., narrower) toward the upper insulating layer 5401, but the diameter of the third input/output contact plug 5404 may become progressively greater toward the upper insulating layer 5401. For example, the third input/output contact plug 5404 may be formed after the second cell region CREG2 and the first cell region CREG1 are bonded to each other by the bonding method.

In some example embodiments, as illustrated in a region 'B2', the third input/output contact plug 5404 may extend in the third direction (e.g., the Z-axis direction), and a diameter of the third input/output contact plug 5404 may become progressively less (e.g., narrower) toward the upper insulating layer 5401. In other words, like the channel structure CH, the diameter of the third input/output contact plug 5404 may become progressively less (e.g., narrower) toward the upper insulating layer 5401. For example, the third input/output contact plug 5404 may be formed together with the cell contact plugs 5440 before the second cell region CREG2 and the first cell region CREG1 are bonded to each other.

In some example embodiments, the input/output contact plug may overlap with the third substrate 5410. For example, as illustrated in a region 'C', the second input/output contact plug 5403 may penetrate the interlayer insulating layer 5415 of the second cell region CREG2 in the third direction (e.g., the Z-axis direction) and may be electrically connected to the second input/output pad 5405 through the third substrate 5410. In this case, a connection structure of the second input/output contact plug 5403 and the second input/output pad 5405 may be realized by various methods.

In some example embodiments, as illustrated in a region 'C1', an opening 5408 may be formed to penetrate the third substrate 5410, and the second input/output contact plug 5403 may be connected directly to the second input/output pad 5405 through the opening 5408 formed in the third substrate 5410. In this case, as illustrated in the region 'C1', a diameter of the second input/output contact plug 5403 may become progressively greater (e.g., wider) toward the second input/output pad 5405. However, the present disclosure is not limited in this regard. For example, in some example embodiments, the diameter of the second input/output contact plug 5403 may become progressively less (e.g., narrower) toward the second input/output pad 5405.

In some example embodiments, as illustrated in a region 'C2', the opening 5408 penetrating the third substrate 5410 may be formed, and a contact 5407 may be formed in the opening 5408. An end of the contact 5407 may be connected to the second input/output pad 5405, and another end of the contact 5407 may be connected to the second input/output contact plug 5403. Thus, the second input/output contact plug 5403 may be electrically connected to the second input/output pad 5405 through the contact 5407 in the opening 5408. In this case, as illustrated in the region 'C2', a diameter of the contact 5407 may become progressively greater (e.g., wider) toward the second input/output pad 5405, and a diameter of the second input/output contact plug 5403 may become progressively less (e.g., narrower) toward the second input/output pad 5405. For example, the second input/output contact plug 5403 may be formed together with the cell contact plugs 5440 before the second cell region CREG2 and the first cell region CREG1 are bonded to each other, and the contact 5407 may be formed after the second cell region CREG2 and the first cell region CREG1 are bonded to each other.

In some example embodiments illustrated in a region 'C3', a stopper 5409 may further be formed on a bottom end of the opening 5408 of the third substrate 5410, as compared with the example embodiments of the region 'C2'. The stopper 5409 may be a metal line formed in the same layer as the common source line 5420. Alternatively or additionally, the stopper 5409 may be a metal line formed in the same layer as at least one of the wordlines 5430. The second input/output contact plug 5403 may be electrically connected to the second input/output pad 5405 through the contact 5407 and the stopper 5409.

Similar to the second and third input/output contact plugs 5403 and 5404 of the second cell region CREG2, a diameter of each of the second and third input/output contact plugs 5303 and 5304 of the first cell region CREG1 may become progressively less (e.g., narrower) toward the lower metal pattern 5371e and/or may become progressively greater (e.g., wider) toward the lower metal pattern 5371e.

In some example embodiments, a slit 5411 may be formed in the third substrate 5410. For example, the slit 5411 may be formed at a certain position of the external pad bonding region PA. For example, as illustrated in a region 'D', the slit 5411 may be located between the second input/output pad 5405 and the cell contact plugs 5440 when viewed in a plan view. Alternatively or additionally, the second input/output pad 5405 may be located between the slit 5411 and the cell contact plugs 5440 when viewed in a plan view.

In some example embodiments, as illustrated in a region 'D1', the slit 5411 may be formed to penetrate the third substrate 5410. For example, the slit 5411 may be used to prevent the third substrate 5410 from being finely cracked when the opening 5408 is formed. However, the present disclosure is not limited in this regard. For example, in some example embodiments, the slit 5411 may be formed to have a depth ranging from about 60% to about 70% of a thickness of the third substrate 5410.

In some example embodiments, as illustrated in a region 'D2', a conductive material 5412 may be formed in the slit 5411. For example, the conductive material 5412 may be used to discharge a leakage current occurring in driving of the circuit elements in the external pad bonding region PA to the outside. In this case, the conductive material 5412 may be connected to an external ground line.

In some example embodiments, as illustrated in a region 'D3', an insulating material 5413 may be formed in the slit 5411. For example, the insulating material 5413 may be used to electrically isolate the second input/output pad 5405 and the second input/output contact plug 5403 disposed in the external pad bonding region PA from the wordline bonding region WLBA. Since the insulating material 5413 is formed in the slit 5411, it may be possible to prevent a voltage provided through the second input/output pad 5405 from affecting a metal layer disposed on the third substrate 5410 in the wordline bonding region WLBA.

In some example embodiments, the first to third input/output pads 5205, 5405 and 5406 may be selectively formed. For example, the memory device 5000 may be realized to include only the first input/output pad 5205 disposed on the first substrate 5210, to include only the second input/output pad 5405 disposed on the third substrate 5410, and/or to include only the third input/output pad 5406 disposed on the upper insulating layer 5401.

In some example embodiments, at least one of the second substrate 5310 of the first cell region CREG1 and the third substrate 5410 of the second cell region CREG2 may be used as a sacrificial substrate and may be completely and/or partially removed before and/or after a bonding process. An additional layer may be stacked after the removal of the substrate. For example, the second substrate 5310 of the first cell region CREG1 may be removed before and/or after the bonding process of the peripheral circuit region PREG and the first cell region CREG1. Subsequently, an insulating layer covering a top surface of the common source line 5320 or a conductive layer for connection may be formed. Similarly, the third substrate 5410 of the second cell region CREG2 may be removed before and/or after the bonding process of the first cell region CREG1 and the second cell region CREG2, and subsequently, the upper insulating layer 5401 covering a top surface of the common source line 5420 or a conductive layer for connection may be formed.

FIG. 33 is a diagram for describing manufacturing processes of a stacked semiconductor device according to example embodiments.

Referring to FIG. 33, respective integrated circuits may be formed on a first wafer WF1 and a second wafer WF2. The memory cell array may be formed in the first wafer WF1 and the peripheral circuits may be formed in the second wafer WF2.

After the various integrated circuits have been respectively formed on the first and second wafers WF1 and WF2, the first wafer WF1 and the second wafer WF2 may be bonded together. The bonded wafers WF1 and WF2 may then be cut (or divided) into separate chips, in which each chip corresponds to a semiconductor device such as, for example, the nonvolatile memory device 5000, including a first semiconductor die SD1 and a second semiconductor die SD2 that are stacked vertically (e.g., the first semiconductor die SD1 is stacked on the second semiconductor die SD2, etc.). Each cut portion of the first wafer WF1 corresponds to the first semiconductor die SD1 and each cut portion of the second wafer WF2 corresponds to the second semiconductor die SD2. The memory device of FIG. 32 may be manufactured according to the process of FIG. 33.

As described above, the storage device and the method of a block reclaim according to example embodiments may efficiently prevent or reduce the occurrence of uncorrectable errors and improve the reliability and performance of the storage device by selectively performing the external copyback operation or the internal copyback operation based on retention characteristics according to physical locations of wordlines.

The various example embodiments may be applied to any electronic devices and systems including a nonvolatile memory device. For example, the various example embodiments may be applied to systems such as a memory card, a solid state drive (SSD), an embedded multimedia card (eMMC), a universal flash storage (UFS), a mobile phone, a smart phone, a personal digital assistant (PDA), a portable multimedia player (PMP), a digital camera, a camcorder, a personal computer (PC), a server computer, a workstation, a laptop computer, a digital TV, a set-top box, a portable game console, a navigation system, a wearable device, an internet of things (IoT) device, an internet of everything (IoE) device, an e-book, a virtual reality (VR) device, an augmented reality (AR) device, a server system, an automotive driving system, etc.

The foregoing is illustrative of various example embodiments and is not to be construed as limiting thereof. Although a few example embodiments have been described, those skilled in the art will readily appreciate that many modifications are possible in the example embodiments without materially departing from the scope as defined by the appended claims.

## Claims

1. A method of block reclaim in a storage device (10) including a nonvolatile memory device (300) and a memory controller (100) that controls the nonvolatile memory device (300), the method comprising:
selecting a source block (SBL) to be a target of a block reclaim from among a plurality of memory blocks included in the nonvolatile memory device (300);
grouping a plurality of wordlines of the source block (SBL) into weak wordlines (WWLs) and strong wordlines (SWLs) based on retention characteristics according to physical locations of the plurality of wordlines;
performing an external copyback operation with respect to the weak wordlines (WWLs), the external copyback operation including error correction; and
performing an internal copyback operation with respect to the strong wordlines (SWLs), the internal copyback operation excluding the error correction.

2. The method of claim 1, wherein performing the external copyback operation comprises transferring, by the nonvolatile memory device (300), read data (RDT) read from memory cells connected to a weak wordline (WWL) of the source block (SBL) to the memory controller (100), and
wherein, in the internal copyback operation, the nonvolatile memory device (300) does not transfer read data (RDT) read from memory cells connected to a strong wordline (SWL) of the source block (SBL) to the memory controller (100).

3. The method of claim 1, wherein performing the external copyback operation comprises correcting, by the memory controller (100), errors in the read data (RDT) read from the memory cells connected to a weak wordline (WWL) of the source block (SBL) to generate corrected data, and transferring, by the memory controller (100), the corrected data to the nonvolatile memory device (300), and writing, by the nonvolatile memory device (300), the corrected data in a destination block (DBL) of the plurality of memory blocks.

4. The method of claim 1, wherein, performing the internal copyback operation comprises writing, by the nonvolatile memory device (300), the read data (RDT) read from the memory cells connected to a strong wordline (SWL) of the source block (SBL) in a destination block (DBL) of the plurality of memory blocks.

5. The method of claim 1, wherein, performing the external copyback operation comprises sequentially transferring, by the memory controller (100), a read command (RD) and a write command (WR) to the nonvolatile memory device (300), wherein the read command (RD) includes a read row address (RADD) corresponding to a weak wordline (WWL) of the source block (SBL) and the write command (WR) includes a write row address (WADD) corresponding to a wordline of a destination block (DBL) of the plurality of memory blocks.

6. The method of claim 1, wherein, performing the internal copyback operation comprises transferring, by the memory controller (100), a single command to the nonvolatile memory device (300), wherein the single command includes a read row address (RADD) corresponding to a strong wordline (SWL) of the source block (SBL) and a write row address (WADD) corresponding to a wordline of a destination block (DBL) of the plurality of memory blocks.

7. The method of claim 1, further comprising:
determining a wordline of the source block (SBL) as a weak wordline (WWL) or a strong wordline (SWL) based on a vertical position of the wordline in the source block (SBL).

8. The method of claim 1, wherein the plurality of wordlines of the source block (SBL) are connected to memory cells that are stacked in a vertical direction and formed in a plurality of channel holes extending in the vertical direction, and the method further comprises determining a wordline of the source block (SBL) as a weak wordline (WWL) or a strong wordline (SWL) based on a height in the vertical direction of the wordline.

9. The method of claim 8, wherein a channel hole of the plurality of channel holes includes a plurality of sub-channel holes that are stacked in the vertical direction, and
wherein the plurality of wordlines of the source block (SBL) are grouped into the weak wordlines (WWLs) and the strong wordlines (SWLs) per sub-channel hole.

10. The method of claim 8, wherein wordlines arranged at a lower portion of the plurality of channel holes are determined as the weak wordlines (WWLs), and wordlines arranged at an upper portion of the plurality of channel holes are determined as the strong wordlines (SWLs).

11. The method of claim 8, wherein wordlines arranged at end portions of the plurality of channel holes are determined as the weak wordlines (WWLs), and wordlines arranged at a central portion between the end portions are determined as the strong wordlines (SWLs).

12. The method of claim 1, wherein, after the external copyback operation with respect to the weak wordlines (WWLs) of the source block (SBL) is completed, the internal copyback operation with respect to the strong wordlines (SWLs) of the source block (SBL) is performed.

13. The method of claim 12, wherein read data (RDT) read by the external copyback operation are stored in the strong wordlines (SWLs) of a destination block (DBL) of the plurality of memory blocks and then the read data (RDT) read by the internal copyback operation are stored in the destination block (DBL).

14. The method of claim 1, further comprising:
performing the block reclaim, and
performing garbage collection while performing the block reclaim such that invalid data stored in the source block (SBL) are discarded and only valid data stored in the source block (SBL) are stored in a destination block (DBL) of the plurality of memory blocks.

15. The method of claim 1, further comprising:
as the retention characteristics of a memory block are deteriorated, a number of the weak wordlines (WWLs) of the memory block increases and a number of the strong wordlines (SWLs) of the memory block decreases.
